(19) Europäisches Patentamt / European Patent Office / Office européen des brevets

(11) **EP 2 683 656 B1**

(12) **FASCICULE DE BREVET EUROPEEN**

(45) Date de publication et mention de la délivrance du brevet:
**21.12.2016 Bulletin 2016/51**

(21) Numéro de dépôt: **12712341.2**

(22) Date de dépôt: **07.03.2012**

(51) Int Cl.:
*C01G 25/00* (2006.01)   *B82Y 30/00* (2011.01)
*H01L 31/032* (2006.01)   *C01G 19/00* (2006.01)
*C01G 23/00* (2006.01)   *B01J 25/00* (2006.01)
*B01J 27/04* (2006.01)   *B01J 35/00* (2006.01)

(86) Numéro de dépôt international:
**PCT/FR2012/050475**

(87) Numéro de publication internationale:
**WO 2012/120237 (13.09.2012 Gazette 2012/37)**

(54) **DISPERSION COLLOÏDALE D'UN MATÉRIAU À L'ÉTAT DIVISÉ FORMÉ DE CHALCOGÉNURE MÉTALLIQUE DANS UN MILIEU AQUEUX, MATÉRIAU À L'ÉTAT DIVISÉ ET LEURS UTILISATIONS**

KOLLOIDALE DISPERSION EINES MATERIALS IN EINEM GETEILTEM ZUSTAND AUS METALLCHALCOGENID IN EINEM WÄSSRIGEN MEDIUM, MATERIAL IN EINEM GETEILTEM ZUSTAND UND SEINE VERWENDUNG

COLLOIDAL DISPERSION OF A MATERIAL IN A DIVIDED STATE AND CONSISTING OF METAL CHALCOGENIDE IN AN AQUEOUS MEDIUM, MATERIAL IN A DIVIDED STATE, AND USES THEREOF

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.03.2011 FR 1100703**

(43) Date de publication de la demande:
**15.01.2014 Bulletin 2014/03**

(73) Titulaires:
• **Université Paul Sabatier Toulouse III**
  **31062 Toulouse (FR)**
• **Centre National de la Recherche Scientifique (C.N.R.S.)**
  **75794 Paris (FR)**
• **Institut National des Sciences Appliquées de Toulouse**
  **31077 Toulouse (FR)**
• **École Supérieure des Beaux-Arts de la Réunion**
  **97826 Le Port (RE)**

(72) Inventeurs:
• **CHANE CHING, Jean-Yves**
  **31650 Saint Orens de Gameville (FR)**
• **ZABERCA, Oana**
  **31200 Toulouse (FR)**
• **TOLESA, Azmach**
  **31400 Toulouse (FR)**
• **BALOCCHI, Andrea**
  **31520 Ramonville Saint Agne (FR)**

(74) Mandataire: **Cabinet BARRE LAFORGUE & associés**
  **35, rue Lancefoc**
  **31000 Toulouse (FR)**

(56) Documents cités:
**WO-A1-2011/030055    WO-A2-2009/137637**

• QIJIE GUO ET AL: "Synthesis of Cu2ZnSnS4 nanocrystal ink and its use in solar cells", JOURNAL OF THE AMERICAN CHEMICAL SOCIETY, AMERICAN CHEMICAL SOCIETY, WASHINGTON, DC; US, vol. 131, no. 33, 26 août 2009 (2009-08-26), pages 11672-11673, XP002566027, ISSN: 0002-7863, DOI: 10.1021/JA904981R [extrait le 2009-07-31]
• TODOROV T ET AL: "Cu2ZnSnS4 films deposited by a soft-chemistry method", THIN SOLID FILMS, ELSEVIER-SEQUOIA S.A. LAUSANNE, CH, vol. 517, no. 7, 2 février 2009 (2009-02-02), pages 2541-2544, XP025928679, ISSN: 0040-6090, DOI: 10.1016/J.TSF.2008.11.035 [extrait le 2008-11-08]

- STEINHAGEN C ET AL: "Synthesis of Cu2ZnSnS4 nanocrystals for use in low-cost photovoltaics", JOURNAL OF THE AMERICAN CHEMICAL SOCIETY, AMERICAN CHEMICAL SOCIETY, WASHINGTON, DC; US, vol. 131, no. 35, 9 septembre 2009 (2009-09-09), pages 12554-12555, XP002566028, ISSN: 0002-7863, DOI: 10.1021/JA905922J [extrait le 2009-08-17] cité dans la demande

**Description**

L'invention concerne une dispersion colloïdale d'un matériau à l'état divisé dans une phase liquide aqueuse. L'invention concerne aussi un tel matériau à l'état divisé formé de particules solides cristallines d'au moins un chalcogénure métallique. L'invention concerne aussi l'utilisation d'une telle dispersion colloïdale pour la fabrication d'un film photo-absorbant d'une cellule photovoltaïque et une cellule photovoltaïque comprenant un tel film photo-absorbant.

Une telle dispersion colloïdale et un tel matériau à l'état divisé trouvent leurs applications dans le domaine de la valorisation des énergies propres et renouvelables -notamment de l'énergie solaire- pour la fabrication d'un film photo-absorbant de faible épaisseur, notamment dans une cellule photovoltaïque.

On connaît des particules de $Cu_2ZnSnS_4$ (Steinhagen et al., (2009), J. Am. Chem. Soc., 131, 12554-12555) de taille de l'ordre de 13 nm obtenues par précipitation contrôlée de précurseurs métalliques dans l'oléylamine. Un tel procédé ne permet pas d'obtenir des particules de taille supérieure à 13 nm et qui soient sensiblement exemptes de carbone. Les particules décrites sont dispersées dans le toluène et ne sont donc pas hydro-compatibles. Un tel procédé ne permet pas non plus l'obtention d'une dispersion concentrée et stable de telles particules dans un solvant aqueux. En outre, les particules décrites sont dispersées dans le toluène qui n'est pas un solvant aqueux et qui est toxique pour l'homme et qui ne respecte pas l'environnement.

WO2011/030055; Guo et al., 2009, JACS, 131(33), 11672-11673 et Todorov et al., 2009,Thin Solid Films, 517(7), 2541-2544 décrivent aussi des particules de $Cu_2ZnSnS_4$.

Ces particules ne sont en outre pas exemptes de surfactant hydrocarboné -notamment d'oléylamine-. En conséquence, une dispersion de tels nano-cristaux dans le toluène ne permet pas la formation d'un film de particules adapté pour permettre la formation par frittage d'un film photoélectrique de qualité photovoltaïque.

L'invention vise à pallier les inconvénients précédemment évoqués en fournissant une dispersion colloïdale d'un matériau à l'état divisé dans une phase liquide aqueuse et un matériau à l'état divisé qui soient de grande pureté et qui sont adaptés pour pouvoir être utilisés pour la fabrication d'un film photo-absorbant de faible épaisseur et présentant un rendement de conversion photovoltaïque élevé.

En particulier, l'invention vise une telle dispersion colloïdale et un tel matériau à l'état divisé permettant, après frittage, la formation d'un film structuré à l'échelle submicronique et à l'échelle nanométrique sur un support, par exemple un support en verre ou en acier revêtu d'une électrode.

L'invention vise aussi une dispersion colloïdale et un matériau à l'état divisé adaptés pour pouvoir permettre la formation d'une couche de particules solides de taille submicronique présentant une densité élevée sur un support et la formation d'un film photoélectrique par frittage de ladite couche de particules.

L'invention vise en outre une telle dispersion colloïdale et un tel matériau à l'état divisé qui soit adaptés pour pouvoir être mis en oeuvre industriellement pour la fabrication de films photo-absorbants de cellules photovoltaïques.

En particulier, l'invention vise une telle dispersion colloïdale et un tel matériau à l'état divisé pour la fabrication de films photo-absorbants qui soient sensiblement exempt de défauts de structure susceptibles de former des pièges de recombinaison électrons/trous.

En particulier, l'invention vise une telle dispersion colloïdale de concentration élevée et qui soit sensiblement exempte d'anion thiocyanate SCN⁻, de thiourée $CS(NH_2)_2$, de thioacétamide $(CH_3\text{-S-}NH_2)$ et leurs produits de dégradation.

L'invention vise aussi un tel matériau à l'état divisé qui soit compatible avec les solvants polaires -notamment qui soit hydrocompatible- et adapté pour pouvoir être dispersé dans une phase liquide aqueuse par simple addition d'eau et pour former une dispersion colloïdale dudit matériau à l'état divisé dans une phase liquide aqueuse, le matériau à l'état divisé étant une poudre redispersable.

L'invention vise aussi un tel matériau à l'état divisé qui soit adapté pour pouvoir former une dispersion colloïdale stable dans une phase liquide aqueuse, y compris à haute concentration du matériau à l'état divisé dans la dispersion colloïdale.

L'invention vise en outre une dispersion colloïdale d'un tel matériau à l'état divisé dans une phase liquide aqueuse qui soit stable dans le temps -notamment vis-à-vis de la décantation-, y compris à haute concentration en matériau à l'état divisé dans une phase liquide aqueuse.

En particulier, l'invention vise une telle dispersion colloïdale et un tel matériau à l'état divisé qui ne comprennent pas de composé hydrocarboné, notamment de composé tensioactif, adsorbé sur ou en interaction avec la surface des particules solides formant ce matériau à l'état divisé.

L'invention vise également à atteindre tous ces objectifs à moindre coût, en proposant une telle dispersion colloïdale et un tel matériau à l'état divisé qui sont de faible coût de fabrication, qui sont réalisés à partir de composants chimiques usuels, abondants dans la nature et/ou peu onéreux.

L'invention vise aussi une dispersion colloïdale d'un tel matériau à l'état divisé dans une phase liquide aqueuse pouvant être appliquée par enduction sur la surface d'un support ou d'un support revêtu d'une électrode de façon à permettre la formation d'une couche mince semi-conductrice dudit matériau à l'état divisé sans nécessiter ni procédé de dépôt sous vide -notamment par pulvérisation sous pression réduite- ni électrodéposition. L'invention vise une telle dispersion colloïdale apte à former une encre adaptée pour pouvoir être enduite en surface d'un support.

L'invention vise en particulier l'utilisation d'une telle dispersion colloïdale, pour la fabrication d'un film mince sur la surface d'un support, en particulier d'un support de forme complexe -notamment un support non plan-.

Pour ce faire, l'invention concerne une dispersion colloïdale d'un matériau à l'état divisé dans une phase liquide aqueuse choisie dans le groupe formé des solutions aqueuses, et des solutions mixtes d'eau et d'au moins un solvant miscible dans l'eau ;

ledit matériau à l'état divisé étant formé de particules solides de composition générale (A) suivante :

$$(Cu^{+1}_2 \; ; Zn^{+2}_{a-v-(y/2)} \; ; Cd^{+2}_v \; ; Sn^{+4}_{b-w-(y/2)}; \; {}^1X^{+4}_w \; ; {}^2X^{+3}_y \; ; S^{-2}_{c-x} \; ; Se^{-2}_x) \qquad (A),$$

où ;

$a, b, c,$ v, $w, x$ et $y$ et leur combinaisons arithmétiques sont des nombres réels qui représentent la proportion molaire de chaque élément auquel chaque nombre est associé dans la formule (A), et tels que :

- $1 \leq a < 1,65$ ;
- $1 \leq b < 1,40$ ;
- $4 < c < 9$, et ;
- v, $w, x$ et $y$ appartiennent indépendamment les uns des autres à l'ensemble des nombre réels appartenant à l'intervalle [0 ; 0,5[, et,

  - ${}^1X^{+4}$ est choisi dans le groupe formé des cations du titane (Ti), des cations du zirconium (Zr) et des cations du plomb (Pb),
  - ${}^2X^{+3}$ est choisi dans le groupe formé des cations du gallium (Ga), des cations de l'indium (In) et des cations de l'yttrium (Y), et ;

le matériau à l'état divisé présentant, par analyse élémentaire, une proportion massique d'élément carbone inférieure à 2,5% notamment inférieure à 2%, particulièrement inférieure à 1%, préférentiellement inférieure à 0,5%, et ;

la dispersion colloïdale présentant une concentration du matériau à l'état divisé dans ladite dispersion colloïdale supérieure à 20 g/L, notamment supérieure à 40 g/L, préférentiellement supérieure à 60 g/L, en particulier supérieure à 80 g/L, plus préférentiellement supérieure à 100 g/L, et ;

la dispersion colloïdale présentant une valeur, déterminée par analyse en mobilité électrophorétique de ladite dispersion colloïdale, de potentiel ζ, dit potentiel zéta, de charge qui est négative et de valeur absolue supérieure à 20 mV, notamment supérieure à 30 mV, préférentiellement supérieure à 40 mV.

Dans toute la suite :

- la « composition générale » des particules solides définit l'ensemble des éléments métalliques constituant les particules solides, chaque élément métallique étant affecté de sa proportion stoechiométrique dans les particules solides. En particulier, ne sont pas considérés dans la composition générale, les éléments non métalliques des particules solides au sens de la classification de Mendeleïev tels que par exemple le carbone, l'azote, l'hydrogène et l'oxygène ;
- l'expression « diamètre équivalent » d'une particule solide désigne le diamètre du cercle de même aire que la projection orthogonale de ladite particule solide sur un plan fictif tangent à ladite particule solide. En particulier, le « diamètre équivalent moyen » des particules solides d'une composition de particules solides peut être évalué par des moyens connus en eux-mêmes notamment à l'aide d'images obtenues par micrographie électronique à transmission ou par microscopie électronique à transmission à haute résolution. On détermine le diamètre équivalent moyen des particules solides d'une composition de particules solides à partir de la mesure du diamètre d'au moins 50 particules solides visualisées sur des clichés de microscopie électronique à transmission, par exemple à un facteur de grossissement compris entre 20 000 et 200 000. La valeur médiane de l'histogramme de distribution des tailles mesurées des particules solides est le diamètre équivalent moyen des particules solides de la composition de particules solides.

Dans une dispersion colloïdale d'un matériau à l'état divisé dans une phase liquide aqueuse, on caractérise les propriétés physico-chimiques du matériau à l'état divisé, séché à température ambiante après séparation dudit matériau à l'état divisé et de la phase liquide aqueuse par centrifugation sous une accélération comprise entre 15000 g et 150000 g à pression atmosphérique et température ambiante, ou par lyophilisation de ladite dispersion colloïdale.

Dans une dispersion colloïdale d'un matériau à l'état divisé dans une phase liquide aqueuse, le matériau à l'état divisé est formé de particules solides de composition générale (A) qui décrit la composition chimique en éléments métalliques des particules solides. Une telle composition chimique peut être déterminée par analyse chimique des particules solides du matériau à l'état divisé selon des moyens connus en eux-mêmes de l'homme du métier. On peut, par exemple, mettre en oeuvre une méthode analytique par spectrométrie d'émission atomique par plasma à couplage inductif ICP.

La dispersion colloïdale d'un matériau à l'état divisé dans une phase liquide aqueuse selon l'invention présente une valeur, déterminée par analyse en mobilité électrophorétique de ladite dispersion colloïdale, de potentiel $\zeta$, dit potentiel zéta, de charge qui est négative et de valeur absolue supérieure à 20 mV. On détermine une telle mesure de la mobilité électrophorétique de la dispersion colloïdale par des moyens connus en eux-mêmes de l'homme du métier par exemple avec un dispositif du type nanosizer (ZetaSizer Nano ZS90, Malvern Instruments, Worcestershire, Angleterre).

Les inventeurs ont observé qu'un matériau à l'état divisé d'une dispersion colloïdale selon l'invention présente une sur-stoechiométrie en anions sulfures par rapport aux chalcogénures $Cu_2ZnSnS_4$ connus de l'état de la technique. Cette sur-stoechiométrie confère au matériau à l'état divisé selon l'invention une charge de surface négative permettant la dispersion dudit matériau dans une phase liquide aqueuse sans apport de composés carbonés dans le matériau à l'état divisé ni dans la phase liquide aqueuse.

En outre, une telle dispersion colloïdale qui est sensiblement exempte de composés carbonés ne nécessite pas un traitement à haute température d'un film formé du matériau à l'état divisé en vue de la combustion oxydative et l'élimination des composés carbonés. En particulier, une telle dispersion colloïdale sensiblement exempte de composés carbonés est adaptée pour pouvoir être mise en oeuvre par frittage sous atmosphère gazeuse inerte et sous atmosphère de sélénium Se en vue de la formation d'un film photo-absorbant d'une cellule photovoltaïque. Un tel frittage sous atmosphère gazeuse inerte ou de Se d'une dispersion colloïdale selon l'invention permet d'obtenir un film photo-absorbant sensiblement exempt d'élément carbone.

Avantageusement, les particules solides sont constituées exclusivement des éléments métalliques de la composition générale (A). En particulier, les particules solides sont exemptes de composé hydrocarboné tensioactif et d'agents de surface tels que des acides gras -notamment d'acides carboxyliques, d'acides sulfoniques et autres-.

Avantageusement, la proportion molaire (a) de l'élément $Zn^{2+}$ dans la composition générale (A) des particules solides est comprise entre 1 et 1,5, en particulier comprise entre 1 et 1,4.

Avantageusement, la proportion molaire (b) de l'élément $Sn^{4+}$ dans la composition générale (A) des particules solides est comprise entre 1 et 1,3, en particulier comprise entre 1 et 1,2.

Avantageusement, la proportion molaire (c) de l'élément $S^{2-}$ dans la composition générale (A) des particules solides est comprise entre 4 et 8, en particulier comprise entre 4 et 6.

Avantageusement, la phase liquide aqueuse est une phase continue dans laquelle sont distribuées les particules solides formant le matériau à l'état divisé et est exempte de composé hydrocarboné tensioactif et d'agents de surface tels que des acides gras -notamment d'acides carboxyliques, d'acides sulfoniques et autres.

Avantageusement, une telle dispersion colloïdale d'un matériau à l'état divisé dans une phase liquide aqueuse est réalisée sans adjonction d'un composé organique carboné, en particulier d'un composé tensioactif susceptible de modifier la tension de surface des particules solides et de ralentir la décantation des particules solides d'une telle suspension colloïdale.

Avantageusement, les particules solides de la dispersion colloïdale selon l'invention présentent une teneur sensiblement nulle en carbone provenant de composés source de sulfures utilisés lors de la synthèse tels que le thiocyanate ($SCN^-$), la thiourée ($CS(NH_2)_2$) et la thioacétamide ($CH_3-S-NH_2$). Les inventeurs ont observé que de telles particules solides exemptes de composé carboné sont adaptées pour permettre l'obtention d'un film photovoltaïque d'efficacité accrue par rapport aux films photovoltaïques de l'état de la technique.

Avantageusement, le matériau à l'état divisé de la dispersion colloïdale selon l'invention présente une proportion massique de l'élément carbone inférieure à 2,5%. La proportion massique de l'élément carbone est déterminée par rapport à la masse sèche du matériau à l'état divisé après lyophilisation de la dispersion colloïdale correspondante.

On détermine la valeur d'une telle proportion d'élément carbone par analyse chimique élémentaire connue en elle-même de l'homme du métier. On peut déterminer cette proportion massique en réalisant une combustion oxydative du matériau à l'état divisé et en mesurant la quantité de gaz carbonique produit lors de cette combustion.

Avantageusement, la dispersion colloïdale selon l'invention est une dispersion colloïdale stable d'un matériau à l'état divisé dans une phase liquide aqueuse choisie dans le groupe formé des solutions aqueuses et des solutions mixtes d'eau et d'au moins un solvant miscible dans l'eau.

Avantageusement et selon l'invention, les particules solides du matériau à l'état divisé présentent un diamètre équivalent moyen compris entre 15 nm et 350 nm, notamment compris entre 15 nm et 300 nm. Le diamètre équivalent moyen des particules solides peut être compris entre 15 nm et 250 nm, notamment entre 15 nm et 300 nm, en particulier entre 15 nm et 250 nm, de préférence compris entre 15 nm et 80 nm.

Les particules solides de composition générale (A) d'une dispersion colloïdale selon l'invention présentent une distribution statistique de taille dans laquelle moins de 10% des particules solides présentent une taille supérieure à deux fois la valeur médiane de la distribution en taille et moins de 10% des particules solides présentent une taille inférieure à la moitié de la valeur médiane de la distribution en taille. Le terme de particule solide désigne une entité solide individualisée. Une telle particule solide peut être sous la forme d'une cristallite élémentaire unique formant une particule solide individualisée ou bien sous la forme d'une pluralité de cristallites associées par agrégation au sein de ladite particule solide individualisée. En tout état de cause, la pluralité de cristallites présente une structure unique par diffraction des rayons X.

Selon un mode particulier de réalisation de l'invention, les particules solides du matériau à l'état divisé selon l'invention sont des particules solides de forme globalement isotropes (sans direction d'allongement privilégiée) dont le diamètre équivalent moyen est compris entre 15 nm et 350 nm.

En particulier, les particules solides d'une dispersion colloïdale selon l'invention présentent, dans un repère spatial orthonormé, trois dimensions orthogonales du même ordre de grandeur.

Avantageusement et selon l'invention, le matériau à l'état divisé présente, par analyse dudit matériau par diffraction des rayons X, une structure cristalline unique. Avantageusement et selon l'invention, la structure cristalline est une structure Kestérite.

L'analyse par diffraction des Rayons X de la structure du matériau à l'état divisé formé de particules solides de composition générale (A) montre un diagramme de diffraction des Rayons X conforme au diagramme de la Kestérite ($Cu_2ZnSnS_4$, JCPDS n°00-026-0575 référencée au « *Joint Committee on Powder Diffraction Standards* ». En particulier, le diagramme de diffraction des rayons X d'un matériau à l'état divisé selon l'invention ne présente pas de raie attribuable à des structures du type $Cu_2S$ (Chalcosine, JCPDS n°01-072-2276), CuS (Coveline, JCPDS n°01-076-1725), SnS (sulfure d'étain, JCPDS n°00-040-1465), $Cu_3SnS_4$ (Pétrukite, JCPDS n°00-036-0217), ZnS (Wurtzite, JCPDS n°00-036-1450, JCPDS n°01-072-0163, JCPDS n°01-075-1534), $Cu_9S_8$ (Yarrowitte, JCPDS n°00-036-0379).

Avantageusement et selon l'invention, les particules solides présentent au moins un domaine, dit domaine cristallin, de taille moyenne, mesurée par diffraction des rayons X, comprise entre 3 nm et 100 nm -notamment comprise entre 3 nm et 80 nm-, ledit domaine cristallin présentant la structure cristalline unique.

La taille moyenne de chaque domaine cristallin des particules solides est déterminée par l'homme du métier par des moyens d'analyse de la diffraction des rayons X (DRX) connus en soi, notamment par application de la formule de Debye et Scherrer.

Avantageusement et selon l'invention, la dispersion colloïdale est adaptée pour que plus de 50% -notamment plus de 75%, préférentiellement plus de 90%- en poids du matériau à l'état divisé reste en suspension dans la dispersion colloïdale après un traitement par centrifugation de ladite dispersion colloïdale sous une accélération de 1250 g pendant une durée de 10 min. Une dispersion colloïdale selon l'invention est une dispersion stable vis-à-vis de la décantation sous une accélération de 1250 g pendant 10 min.

En particulier, on réalise ce traitement par centrifugation d'une telle dispersion colloïdale à température ambiante dans laquelle le matériau à l'état divisé est en suspension dans une phase liquide aqueuse formée d'eau. En fait, les particules solides d'une telle dispersion colloïdale selon l'invention ne forment pas d'agrégats.

Les inventeurs ont observé que les particules solides d'une dispersion colloïdale selon l'invention forment une suspension stable dans les solvants aqueux alors que les nano-cristaux de l'état de la technique sont soit modifiés en surface par des agents de surface de nature organique, soit adaptés pour pouvoir être dispersés uniquement dans des solvants apolaires -notamment dans le toluène-. De tels nano-cristaux de l'état de la technique présentent une couche de surface de nature hydrophobe et apolaire -en particulier de nature carbonée-enrobant lesdits nano-cristaux et qui ne permettent pas l'obtention d'un film photo-absorbant de haute performance.

Les inventeurs ont constaté qu'il est possible de réaliser une dispersion colloïdale d'un matériau formé de particules solides de composition générale (A) dans une phase liquide aqueuse et présentant en outre une concentration en particules solides qui est élevée et adaptée pour permettre son utilisation à l'échelle industrielle, mais qui est en même temps stable dans le temps. En particulier, les inventeurs ont observé qu'une telle dispersion colloïdale est adaptée pour pourvoir être mise en oeuvre dans des dispositifs robotisés d'application de solutions liquides sur divers substrats.

Avantageusement et selon l'invention, les particules solides du matériau à l'état divisé présentent, par spectroscopie Raman, une raie de diffusion, dite raie primaire, présentant une intensité maximum de diffusion à une valeur de nombre d'onde comprise entre 310 $cm^{-1}$ et 340 $cm^{-1}$ -notamment comprise entre 330 $cm^{-1}$ et 340 $cm^{-1}$ -en particulier sensiblement de l'ordre de 336 $cm^{-1}$-.

Avantageusement, la raie primaire présente une largeur de raie à mi-hauteur comprise entre 5 $cm^{-1}$ et 60 $cm^{-1}$ -notamment comprise entre 5 $cm^{-1}$ et 30 $cm^{-1}$-.

Avantageusement dans une première variante d'une dispersion colloïdale selon l'invention, le matériau à l'état divisé est formé de particules solides poly-cristallines. Dans de telles particules solides poly-cristallines, le diamètre équivalent moyen du(des) domaine(s) cristallin(s) des particules solides constitutives du matériau à l'état divisé, mesuré par diffraction des rayons X, est inférieur au diamètre équivalent moyen desdites particules solides.

Dans cette première variante, avantageusement et selon l'invention, le matériau à l'état divisé est formé de particules solides présentant un diamètre équivalent moyen compris entre 15 nm et 350 nm et dont la taille moyenne du domaine cristallin est comprise entre 4 nm et 20 nm.

Avantageusement, dans cette première variante d'une dispersion colloïdale selon l'invention, le matériau à l'état divisé présente, par spectroscopie Raman, une raie de diffusion, dite raie primaire, présentant une intensité maximum de diffusion à une valeur de nombre d'onde comprise entre 330 cm$^{-1}$ et 340 cm$^{-1}$ -notamment sensiblement de l'ordre de 336 cm$^{-1}$- et une largeur de raie à mi-hauteur comprise entre 5 cm$^{-1}$ et 60 cm$^{-1}$.

Avantageusement dans une deuxième variante d'une dispersion colloïdale selon l'invention, le matériau à l'état divisé est formé de particules solides poly-cristallines présentant un diamètre équivalent moyen compris entre 15 nm et 300 nm et dont la taille moyenne du domaine cristallin est comprise entre 15 nm et 80 nm.

Dans de telles particules solides poly-cristallines, le diamètre moyen de chaque domaine cristallin des particules solides constitutives du matériau à l'état divisé, mesuré par diffraction des rayons X, est inférieur au diamètre équivalent moyen desdites particules solides.

Avantageusement, dans cette deuxième variante d'une dispersion colloïdale selon l'invention, le matériau à l'état divisé présente, par spectroscopie Raman, une raie de diffusion, dite raie primaire, présentant une intensité maximum de diffusion à une valeur de nombre d'onde comprise entre 330 cm$^{-1}$ et 340 cm$^{-1}$ -notamment sensiblement de l'ordre de 336 cm$^{-1}$- et une largeur de raie à mi-hauteur comprise entre 5 cm$^{-1}$ et 30 cm$^{-1}$.

Avantageusement et dans une troisième variante d'une dispersion colloïdale selon l'invention, la taille moyenne de chaque domaine cristallin des particules solides constitutives du matériau à l'état divisé, mesurée par diffraction des rayons X, est sensiblement de l'ordre de grandeur du diamètre équivalent moyen desdites particules solides.

Avantageusement dans cette troisième variante d'une dispersion colloïdale selon l'invention, les particules solides constitutives du matériau à l'état divisé sont des particules solides monocristallines. De telles particules solides monocristallines présentent un diamètre équivalent moyen déterminé par microscopie électronique qui est de l'ordre de grandeur -notamment sensiblement égal- au diamètre moyen des domaines cristallins déterminé par diffraction des rayons X. Avantageusement, la dispersion colloïdale selon l'invention est formée d'un matériau à l'état divisé formé de particules solides monocristallines.

Dans cette troisième variante, avantageusement et selon l'invention, la dispersion colloïdale comprend des particules solides présentant un diamètre équivalent moyen compris entre 15 nm et 80 nm -notamment compris entre 15 nm et 60 nm- et dont la taille moyenne du domaine cristallin est comprise entre 15 nm et 60 nm.

Avantageusement, dans cette troisième variante d'une dispersion colloïdale selon l'invention, le matériau à l'état divisé présente, par spectroscopie Raman, une raie de diffusion, dite raie primaire, présentant une intensité maximum de diffusion à une valeur de nombre d'onde comprise entre 330 cm$^{-1}$ et 340 cm$^{-1}$ -notamment sensiblement de l'ordre de 336 cm$^{-1}$- et une largeur de raie à mi-hauteur comprise entre 5 cm$^{-1}$ et 22 cm$^{-1}$.

Avantageusement, le matériau à l'état divisé de la dispersion colloïdale selon l'invention présente, par spectroscopie Raman, une raie de diffusion secondaire, présentant une intensité maximum de diffusion à une valeur de nombre d'onde comprise entre 260 cm$^{-1}$ et 295 cm$^{-1}$, notamment entre 260 cm$^{-1}$ et 285 cm$^{-1}$.

Avantageusement, le matériau à l'état divisé présente, par spectroscopie Raman, une raie de diffusion secondaire additionnelle, présentant une intensité maximum de diffusion à une valeur de nombre d'onde comprise entre 355 cm$^{-1}$ et 375 cm$^{-1}$ -notamment comprise entre 360 cm$^{-1}$ et 370 cm$^{-1}$, préférentiellement de l'ordre de 365 cm$^{-1}$.

Avantageusement, un matériau à l'état divisé d'une dispersion colloïdale selon l'invention peut présenter au moins l'une des caractéristiques suivantes :

- une fraction des cations du zinc ($Zn^{+2}$) est substituée par des cations du cadmium ($Cd^{+2}$),
- une fraction des cations du zinc ($Zn^{+2}$) peut être sous la forme de colloïde ZnS de faible taille ou sous forme de complexes sulfures métallique s'étendant en surface des particules,
- une fraction des cations de l'étain ($Sn^{+4}$) est substituée par des cations du titane ($Ti^{+4}$), du zirconium ($Zr^{+4}$) ou du plomb ($Pb^{+4}$),
- une fraction des cations de l'étain ($Sn^{+4}$) peut être sous la forme de colloïde SnS, $SnS_2$ de faible taille ou sous forme de complexes sulfures métalliques s'étendant en surface des particules solides,
- une même fraction des cations du zinc ($Zn^{+2}$) et des cations de l'étain ($Sn^{+4}$) est substituée par des cations choisis dans le groupe formé des cations du gallium ($Ga^{+3}$), des cations de l'indium ($In^{+3}$) et de l'yttrium ($Y^{+3}$),
- une fraction des cations $In^{3+}$ et $Ga^{3+}$ est sous forme de colloïdes $Ga_2S_3$, $In_5S_3$ ou sous forme de complexe sulfure métallique en surface des particules solides,
- une fraction des anions du soufre ($S^{-2}$) est substituée par des anions du sélénium ($Se^{-2}$).

Avantageusement et selon l'invention, le solvant miscible dans l'eau est choisi dans le groupe formé des alcools -notamment du méthanol, de l'isopropanol et de l'alcool éthylique- et de l'acétonitrile.

Avantageusement et selon l'invention, la phase liquide aqueuse présente une valeur de pH inférieure à pH 10,5, notamment inférieure à pH 10, de préférence inférieure à pH 9,5.

Dans une dispersion colloïdale d'un matériau à l'état divisé dans une phase liquide aqueuse, on caractérise les propriétés physico-chimiques de la phase liquide aqueuse après séparation de la phase liquide aqueuse et du matériau à l'état divisé par centrifugation sous une accélération comprise entre 15000 g et 150000 g à pression atmosphérique et température ambiante, ou par lyophilisation de ladite dispersion colloïdale.

Avantageusement, la phase liquide aqueuse comprend des clusters inorganiques de sulfures métalliques et des nanoparticules de sulfures métalliques stabilisées par de tels clusters inorganiques de sulfures métalliques. De telles nanoparticules de sulfures métalliques sont en particulier formées lorsque les clusters inorganiques sont réalisés à partir de solutions salines présentant un rapport molaire Zn/Sn élevé, notamment supérieur à 2. Ces nanoparticules de sulfures métalliques présentent une taille moyenne inférieure à 20 nm, de préférence inférieure à 10 nm, de préférence inférieure à 5 nm.

La présence de ces nanoparticules de sulfures métalliques en surface des particules solides -notamment de CZTS- peut être mise en évidence par microscopie électronique à transmission.

Avantageusement et selon l'invention, la phase liquide aqueuse comprend au moins un soluté choisi dans le groupe formé du $(NH_4)_2S$, du $Sn_2S_6(NH_4)_4$, des complexes métalliques à base de Zn, de Sn, de Ga et d'In et des nanoparticules à base de Zn et de Sn dans une proportion massique dans la phase liquide aqueuse inférieure à 10%, notamment inférieure à 5%, de la masse sèche totale de la dispersion colloïdale.

La phase liquide aqueuse est une phase continue qui peut également contenir des complexes de sulfures de Zn, de Sn, d'In de Ga, par exemple du type $Sn_2S_6(NH_4)_4$ et des nanoparticules de sulfures métalliques stabilisées par des complexes sulfures métalliques. La masse des cations solubles dans la phase liquide aqueuse est inférieure à 10%, de préférence inférieure à 5%, de la masse sèche totale de la dispersion colloïdale.

On réalise une telle analyse de la phase liquide aqueuse par Résonnance Magnétique Nucléaire (RMN) liquide du [119]Sn. La phase liquide aqueuse présente au moins un signal de résonance attribuable à des nanoparticules de sulfures métalliques ou à des complexes de sulfures métalliques. Un signal de résonance est observé à un déplacement chimique $\delta$ compris entre 54 et 57 ppm. La publication (J. Am. Chem. Soc., 2010, 132 ; 29, 10085-10092), attribue le signal de résonance à 56.3 ppm au complexe $(Sn_2S_6)^{4-}$.

Des signaux de résonance attribuables à des formes moins condensées de type ortho-thiostannate ou métathiostannate peuvent également être observés dans la plage de déplacement chimique couvrant de 66 ppm à 70 ppm, ou encore dans la plage de déplacement chimique couvrant de 78 ppm à 88 ppm.

Avantageusement et selon l'invention, le matériau à l'état divisé de la dispersion colloïdale présente, par analyse en Résonnance Magnétique Nucléaire en phase solide du $^{119}$Sn, au moins un signal de résonance à une valeur de déplacement chimique de l'élément $^{119}$Sn comprise entre -350 ppm et -750 ppm, notamment entre -500 ppm et -650 ppm, préférentiellement entre -520 ppm et -600 ppm. On réalise une telle analyse par RMN solide du $^{119}$Sn du matériau à l'état divisé après séparation du matériau solide et de la phase liquide aqueuse de la dispersion colloïdale comme décrit ci-dessus.

Avantageusement et selon l'invention, le matériau à l'état divisé présente, par analyse en spectrométrie infrarouge, au moins une bande d'absorption présentant une valeur maximale d'intensité d'absorption à une valeur de nombre d'onde comprise entre 1390 $cm^{-1}$ et 1420 $cm^{-1}$.

Avantageusement et selon l'invention, le matériau à l'état divisé présente, par analyse en spectrométrie infrarouge, au moins une bande d'absorption présentant une valeur maximale d'intensité d'absorption à une valeur de nombre d'onde comprise entre 1590 $cm^{-1}$ et 1625 $cm^{-1}$.

On réalise une analyse par spectroscopie infrarouge du matériau à l'état divisé obtenu par lyophilisation d'une dispersion colloïdale selon l'invention et conditionné sous la forme d'une pastille de bromure de potassium (KBr) sec connue de l'homme du métier.

Avantageusement et selon l'invention, la dispersion colloïdale présente un rapport $\left(\dfrac{a-v-\dfrac{y}{2}}{b-w-\dfrac{y}{2}}\right)$ molaire de $\dfrac{Zn}{Sn}$ supérieur à 1, notamment supérieur à 1,1, de préférence supérieur à 1,2.

Avantageusement et selon l'invention, la dispersion colloïdale présente un rapport

$$\frac{2}{(a-v-\frac{y}{2})+(b-w-\frac{y}{2})}$$ molaire de $\frac{Cu}{Zn+Sn}$ compris entre 0,7 et 1,0, notamment compris entre 0,75 et 1,0, de préférence compris entre 0,8 et 1,0.

Avantageusement, les particules solides de la dispersion colloïdale selon l'invention dispersée dans la phase liquide aqueuse sont des particules solides chargées en surface. Cette charge de surface est déterminée de façon connue de l'homme du métier par des mesures de mobilité électro-phorétique. En particulier, la phase liquide aqueuse est de faible force ionique et est adaptée pour ne pas produire une constante d'écran vis-à-vis des charges des particules solides.

L'invention concerne aussi un matériau à l'état divisé formé de particules solides de composition générale (A) suivante :

$$(Cu^{+1}{}_2 \; ; \; Zn^{+2}{}_{a-v-(y/2)} \; ; \; Cd^{+2}{}_v \; ; \; Sn^{+4}{}_{b-w-(y/2)} \; ; \; {}^1X^{+4}{}_w \; ; \; {}^2X^{+3}{}_y \; ; \; S^{-2}{}_{c-x} \; ; \; Se^{-2}{}_x) \qquad (A),$$

où ;

$a, b, c,$ v, $w, x$ et $y$ et leur combinaisons arithmétiques sont des nombres réels qui représentent la proportion molaire de chaque élément auquel chaque nombre est associé dans la formule (A), et tels que :

- $1 \le a < 1,65$ ;
- $1 \le b < 1,40$ ;
- $4 \le c < 9$, et ;
- v, $w, x$ et $y$ appartiennent indépendamment les uns des autres à l'ensemble des nombre réels appartenant à l'intervalle [0 ; 0,5[, et,

- ${}^1X^{+4}$ est choisi dans le groupe formé des cations du titane (Ti), des cations du zirconium (Zr) et des cations du plomb (Pb),
- ${}^2X^{+3}$ est choisi dans le groupe formé des cations du gallium (Ga), des cations de l'indium (In) et des cations de l'yttrium (Y) ;

ledit matériau présentant :

- par analyse dudit matériau par diffraction des rayons X, une structure cristalline unique ;
- par analyse élémentaire, une proportion massique d'élément carbone inférieure à 2,5%, notamment inférieure à 2,0%, particulièrement inférieure à 1,0%, préférentiellement inférieure à 0,5%.

Avantageusement, la proportion molaire (a) de l'élément $Zn^{2+}$ dans la composition générale (A) des particules solides est comprise entre 1 et 1,5, en particulier comprise entre 1 et 1,4.

Avantageusement, la proportion molaire (b) de l'élément $Sn^{4+}$ dans la composition générale (A) des particules solides est comprise entre 1 et 1,3, en particulier comprise entre 1 et 1,2.

Avantageusement, la proportion molaire (c) de l'élément $S^{2-}$ dans la composition générale (A) des particules solides est comprise entre 4 et 8, en particulier comprise entre 4 et 6.

Avantageusement et selon l'invention, le matériau à l'état divisé est adapté pour pouvoir former une dispersion colloïdale dudit matériau à l'état divisé dans une phase liquide aqueuse choisie dans le groupe formé des solutions aqueuses et des solutions mixtes d'eau et d'au moins un solvant miscible dans l'eau.

Avantageusement et selon l'invention, les particules solides du matériau à l'état divisé présentent, par spectroscopie Raman, une raie de diffusion, dite raie primaire, présentant une intensité maximum de diffusion à une valeur de nombre d'onde comprise entre 310 cm$^{-1}$ et 340 cm$^{-1}$.

Avantageusement et selon l'invention, les particules solides du matériau présentent un diamètre équivalent moyen compris entre 15 nm et 350 nm, notamment compris entre 15 nm et 300 nm. Le diamètre équivalent moyen des particules solides peut être compris entre 15 nm et 250 nm -notamment entre 15 nm et 80 nm.

Avantageusement et selon l'invention, les particules solides du matériau présentent au moins un domaine, dit domaine cristallin, de taille moyenne, mesurée par diffraction des rayons X, comprise entre 3 et 100 nm, notamment entre 15 nm et 80 nm, ledit domaine cristallin présentant la structure cristalline unique. Avantageusement, la structure cristalline est une structure Kestérite.

Avantageusement et selon l'invention, le matériau à l'état divisé présente, par analyse en Résonance Ma-

gnétique Nucléaire en phase solide du $^{119}$Sn, au moins un signal de résonance à une valeur de déplacement chimique de l'élément $^{119}$Sn comprise entre -350 ppm et -750 ppm, notamment entre -500 ppm et -650 ppm, préférentiellement entre -520 ppm et -600 ppm.

Avantageusement et selon l'invention, le matériau à l'état divisé présente, par analyse en spectrométrie infrarouge, au moins une bande d'absorption présentant une valeur maximale d'intensité d'absorption à une valeur de nombre d'onde comprise entre 1390 cm$^{-1}$ et 1420 cm$^{-1}$.

Avantageusement et selon l'invention, le matériau à l'état divisé présente, par analyse en spectrométrie infrarouge, au moins une bande d'absorption présentant une valeur maximale d'intensité d'absorption à une valeur de nombre d'onde comprise entre 1590 cm$^{-1}$ et 1625 cm$^{-1}$.

On réalise une analyse par spectroscopie infrarouge du matériau à l'état divisé obtenu par lyophilisation d'une dispersion colloïdale selon l'invention et conditionnée sous la forme d'une pastille de bromure de potassium (KBr) sec connue de l'homme du métier.

L'invention concerne aussi un tel matériau à l'état divisé selon l'invention obtenu par lyophilisation, à une pression inférieure à 10 hPa, de préférence à une pression de l'ordre de 0,5 hPa et à une température inférieure à -80°C, notamment inférieure à -60°C, de préférence inférieure à -40°C, d'une dispersion colloïdale selon l'invention.

L'invention concerne aussi un procédé de préparation d'une dispersion colloïdale selon l'invention, dans lequel :

- on prépare une solution aqueuse de sels de cations métalliques choisis dans le groupe formé du Zn$^{2+}$, du Sn$^{2+}$, du Sn$^{4+}$, du Cd$^{2+}$, du In$^{3+}$, du Ga$^{3+}$ et du Y$^{3+}$ et d'au moins un acide minéral, la concentration molaire des cations métalliques dans la solution aqueuse étant comprise entre 0,05 mol/L et 0,5 mol/L puis ;
- on prépare une solution, dite solution de sulfure, aqueuse ou hydroalcoolique d'au moins un sulfure choisi dans le groupe formé de Na$_2$S et de (NH$_4$)$_2$S, puis ;
- on réalise au moins une étape d'addition de la solution aqueuse de sels de cations métalliques dans la solution de sulfure de façon à former une solution de complexes de sulfures métalliques, dits clusters inorganiques, puis ;
- on met en contact et on incube :

  ○ une quantité de la solution de cluster inorganique ;
  ○ une quantité de particules présentant :

    ▪ par diffraction des Rayons X une structure cristalline Cu$_2$ Zn Sn S$_4$ du type Kestérite ou Kestérite dopée, et ;
    ▪ un diamètre équivalent moyen compris entre 15 nm et 350 nm ;

  ○ éventuellement, une quantité d'une solution aqueuse d'au moins un sulfure à une concentration comprise entre 0,01 mol/L et 1 mol/L ;

  - on réalise une étape de séparation -notamment par centrifugation- de particules solides et de la solution aqueuse ;
  - on disperse le culot avec une solution aqueuse ou hydroalcoolique contenant éventuellement au moins un sulfure du type (NH$_4$)$_2$S, de façon à former une suspension colloïdale d'un matériau à l'état divisé dans une phase liquide aqueuse, le matériau présentant, par analyse élémentaire, une proportion massique en élément carbone inférieure à 2,5%, notamment inférieure à 2%, particulièrement inférieure à 1%, préférentiellement inférieure à 0,5%, la dispersion colloïdale présentant une concentration du matériau à l'état divisé dans ladite dispersion colloïdale supérieure à 20 g/L, notamment supérieure à 40 g/L, préférentiellement supérieure à 60 g/L, en particulier supérieure à 80 g/L, plus préférentiellement supérieure à 100 g/L.

L'invention vise aussi un procédé de fabrication d'une dispersion colloïdale selon l'invention, dans lequel on ajoute, à une quantité d'un matériau à l'état divisé selon l'invention sous forme d'une poudre sèche, un volume d'une phase liquide aqueuse choisie dans le groupe formé des solutions aqueuses et des solutions mixtes d'eau et d'au moins un solvant miscible dans l'eau de façon à former une dispersion colloïdale présentant une concentration du matériau dans ladite dispersion colloïdale supérieure à 20 g/L, notamment supérieure à 40 g/L, préférentiellement supérieure à 60 g/L, en particulier supérieure à 80 g/L, plus préférentiellement supérieure à 100 g/L. On réalise une telle dispersion colloïdale par simple addition d'eau au matériau à l'état divisé.

La phase liquide aqueuse contient une concentration en (NH$_4$)$_2$S inférieure à 0,1 mol/L, notamment inférieure à 0,05 mol/L, de préférence inférieure à 0,01 mol/L.

L'invention vise aussi l'utilisation d'un matériau solide selon l'invention pour la préparation d'une dispersion colloïdale selon l'invention, dans laquelle on réalise une dispersion colloïdale dudit matériau à l'état divisé dans une phase liquide aqueuse choisie dans le groupe formé des solutions aqueuses et des solutions mixtes d'eau et d'au moins un solvant miscible dans l'eau.

L'invention vise aussi l'utilisation d'une dispersion colloïdale selon l'invention pour la fabrication d'un film photo-absorbant d'une cellule photovoltaïque, dans laquelle :

- on place une quantité de ladite dispersion colloïdale sur un support solide de façon à former un film de ladite dispersion colloïdale s'étendant en surface dudit support et d'épaisseur comprise entre 0,1 $\mu$m et 5 $\mu$m, puis ;
- on réalise une étape de traitement par frittage dudit film sous atmosphère de Se.

L'invention concerne également une dispersion colloïdale, un matériau à l'état divisé et l'utilisation d'une telle dispersion colloïdale pour la fabrication de cellules photovoltaïques, caractérisés en combinaison par tout ou partie des caractéristiques mentionnées ci-dessus ou ci-après.

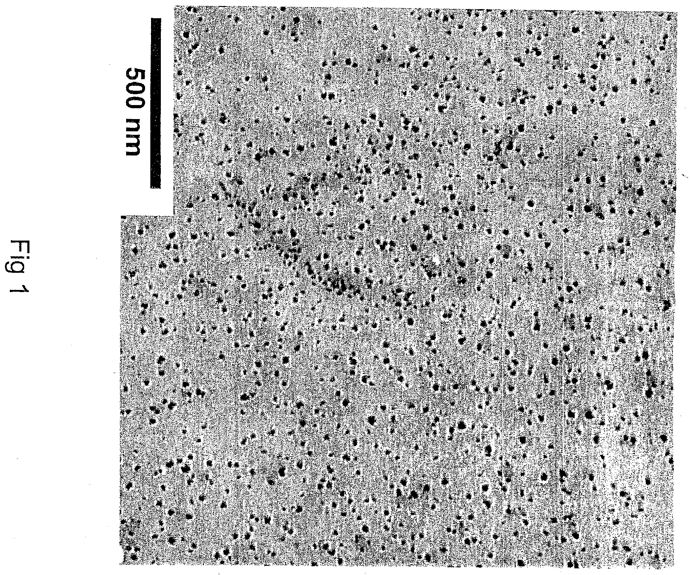

D'autres buts, caractéristiques et avantages de l'invention apparaîtront à la lecture de la description suivante illustrant des modes de réalisation préférentiels de l'invention par des exemples non limitatifs de préparation de dispersions colloïdales à partir de matériaux à l'état divisé et de procédés d'obtention de tels matériaux selon l'invention et dans lesquels la figure 1 représente un cliché en microscopie électronique à transmission (MET) d'une dispersion colloïdale selon l'invention.

Un procédé d'obtention d'une suspension colloïdale d'un matériau à l'état divisé dans une phase liquide aqueuse donné à titre d'exemple non limitatif est décrit ci-après. Dans un tel procédé de préparation d'une dispersion colloïdale d'un matériau à l'état divisé comprenant des particules solides de composition générale (A), on prépare des particules de structure cristalline du type késtérite ou késtérite dopée. Pour ce faire :

- (i) on choisit au moins un précurseur de chaque élément constitutif du matériau à l'état divisé de formule (A) ;
- (ii) on prépare une composition, dite composition de précurseurs, solide par mélange du(des) précurseurs de chaque élément constitutif du matériau solide de composition générale (A), puis ;
- (iii) on place cette composition de précurseurs dans une enceinte sous atmosphère d'un gaz inerte à une température de l'ordre de la température ambiante ;
- (iv) on chauffe la composition de précurseurs lors d'une étape, dite étape en sels fondus, selon un taux d'accroissement de la température compris entre 0,5°C/min et 10,0°C/min et adapté pour que la température de l'enceinte atteigne une température de synthèse, comprise entre 250°C et 500°C - notamment comprise entre 350°C et 450°C-, et on maintient ladite température de synthèse pendant une durée de synthèse, comprise entre 2 h et 36 h -notamment comprise entre 4 h et 26 h- de façon à former un matériau recristallisé présentant une structure unique par diffraction des rayons X, puis,
- (v) on réalise, après refroidissement du matériau recristallisé, un traitement de séparation et de lavage d'un matériau solide de formule (A) exempt de précurseurs,
- (vi) ultérieurement à ces étapes (i) à (v), on soumet le matériau solide de composition générale (A) exempt de précurseurs à une étape de réduction de sa granulométrie -notamment par broyage-,
- (vii) puis on réalise une étape de sélection des particules du matériau de granulométrie ainsi réduite adaptée pour conserver les particules de granulométrie la plus faible.

Un tel traitement en sels fondus d'une composition de précurseurs, à une température comprise entre 250°C et 500°C -notamment comprise entre 350°C et 450°C- permet de former une poudre de particules cristallisées et de taille nanométrique par précipitation ou, de préférence, par dissolution/re-précipitation accompagné d'une recristallisation, de ladite composition de précurseurs.

Dans un tel procédé, on choisit :

- le(s) précurseur(s) de cuivre (Cu) dans le groupe formé du chlorure cuivreux (CuCl), du chlorure cuivrique di-hydraté (CuCl$_2$ 2H$_2$O), du nitrate de cuivre (Cu(NO$_3$)$_2$), de l'acétate de cuivre (CH$_3$COO)$_2$Cu), des hydroxydes de Cu fraichement préparés et des (oxy)hydroxydes de Cu fraichement préparés ;
- le(s) précurseur(s) d'étain (Sn) dans le groupe formé du chlorure stannique hydraté (SnCl$_4$ 5H$_2$O), de l'acétate stannique ((CH$_3$COO)$_4$Sn), des hydroxydes de Sn$^{+4}$ fraichement préparés et des (oxy)hydroxydes de Sn$^{+4}$ fraichement préparés ;
- le(s) précurseur(s) de zinc (Zn) dans le groupe formé du chlorure de zinc (ZnCl$_2$), de l'acétate de zinc (CH$_3$COO)$_2$Zn), des hydroxydes de Zn$^{+2}$ fraichement préparés et des (oxy)hydroxydes de Zn$^{+2}$ fraichement préparés ;
- le(s) précurseurs(s) d'anion(s) dans le groupe formé du thiocyanate de potassium (K-S-C=N), de la thio-urée (S=C(NH$_2$)$_2$) du sulfure de sodium hydraté (Na$_2$S, 9H$_2$O), du sulfure de sodium (Na$_2$S), de la thioacétamide (NH$_2$SCH$_3$), du sélénocyanate de potassium (K Se C N) et de la séléno-urée (SeC(NH$_2$)$_2$),
- le(s) précurseurs(s) de dopant(s) dans le groupe formé du chlorure de gallium (GaCl$_3$), du chlorure de cadmium

(CdCl$_2$), du nitrate de gallium (Ga(NO$_3$)$_3$), du nitrate de cadmium (Cd(NO$_3$)$_3$), de l'iodure de cadmium (CdI$_2$) et de l'acétate de plomb (CH$_3$COO)$_4$Pb), du nitrate d'yttrium (Y(NO$_3$)$_3$), des (oxy)hydroxydes de gallium, des (oxy)hydroxydes de plomb et des (oxy)hydroxydes d'yttrium.

Dans une étape ultérieure d'un procédé de préparation d'une dispersion colloïdale selon l'invention, on réalise un traitement de particules cristallines d'un chalcogénure métallique -notamment de CZTS, Cu$_2$ZnSnS$_4$- par mise en contact d'une suspension desdites particules cristallines dans l'eau ou d'un culot humide desdites particules cristallines -obtenu par centrifugation- et d'une solution de clusters inorganiques, notamment à base de cations de Zn, de cations de Sn, de cations d'In, de cations de Ga et d'anions sulfures.

Préparation de la solution de clusters inorganiques

On prépare une solution aqueuse de sels de cations métalliques comprenant des cations Zn$^{2+}$ -par exemple sous la forme de (ZnCl$_2$)- et des cations Sn$^{2+}$ ou Sn$^{4+}$ -par exemple sous la forme de (SnCl$_4$)-. Le rapport molaire Zn$^{2+}$/(Sn$^{2+}$+Sn$^{4+}$) est compris entre 0 et 4, notamment compris entre 1 et 3, de préférence compris entre 1 et 2,5. Le pH de la solution aqueuse de sels de cations métalliques doit être ajusté de façon que le rapport molaire H$^+$/cation métallique dans la solution aqueuse de sels de cations métalliques soit compris entre 0,5 et 1,5. On ajuste la proportion de H$^+$ dans la solution aqueuse de sels de cations métalliques par addition d'une quantité d'un acide minéral choisi dans le groupe formé de HCl, de H$_2$SO$_4$ et de HNO$_3$. Dans ces conditions, le pH de la solution de clusters inorganiques obtenue par addition ultérieure de la solution de sulfures est compris entre pH 8,5 et pH 10,5, de préférence compris entre pH 8,5 et pH 10,0, préférentiellement entre pH 8,5 et pH 9,75.

La concentration totale en sels de cations métalliques dans la solution aqueuse de sels de cations métalliques est comprise entre 0,01 mole/L et 0,50 mole/L, de préférence comprise entre 0,05 mole/L et 0,3 mole/L.

Il est possible que la solution aqueuse de cations métalliques comprenne des cations métalliques dopants M$^{3+}$ choisis parmi l'In$^{3+}$ (Indium), le Ga$^{3+}$ (Gallium) et l'Y$^{3+}$ (Yttrium). Les proportions molaires ($\alpha$/$\beta$/$\gamma$) des cations métalliques Zn/Sn/M dans la solution aqueuse de cations métallique est telle que :

$$0,0 \leq \alpha < 0,8 \ ;$$
$$0,2 < \beta \leq 1,0;$$
$$0,00 \leq \gamma < 0,4.$$

Les cations métalliques dopants sont apportés dans la solution aqueuse de cations métalliques par dissolution de sels, notamment de chlorure, choisis parmi InCl$_3$, InCl$_3$ nH$_2$O.

On prépare en outre une solution aqueuse d'au moins un sulfure S$^{2-}$, par exemple de sulfure de sodium Na$_2$S ou (NH$_4$)$_2$S.

On forme la solution de clusters inorganiques par addition instantanée ou progressive et contrôlée à température ambiante d'une durée supérieure à 30 min, notamment supérieure à 1 h, en particulier de l'ordre de 3 h, de la solution aqueuse de sels de cations métalliques dans la solution aqueuse d'au moins un sulfure S$^{2-}$. On laisse le mélange au repos et à température ambiante pendant une durée supérieure à 2 h, de préférence supérieure à 4 h. On obtient une solution visuellement limpide dont le pH est compris entre pH 8,5 et pH 11 et contenant les clusters inorganiques.

Le rapport molaire des sulfures S$^{2-}$ et des cations métalliques dans la solution de clusters inorganiques est compris entre 2 et 6, de préférence compris entre 2 et 4.

On met en contact une quantité de particules cristallines d'un chalcogénure métallique en suspension dans l'eau ou sous forme d'un culot de centrifugation humide avec une quantité de la solution de clusters inorganiques sous agitation vigoureuse. Le temps de contact varie de 15 min à 24 h. On dilue ensuite éventuellement le mélange avec une solution aqueuse de (NH$_4$)$_2$S à une concentration de 0,01 mol/L. Il est possible de renouveler cette opération de contact du culot solide obtenu par centrifugation avec la solution de cluster inorganique. On effectue une élimination des impuretés par centrifugation et dispersion du culot de centrifugation dans une solution de (NH$_4$)$_2$S 0,01 mol/L de façon à obtenir une dispersion colloïdale d'un matériau à l'état divisé de formule Cu$_2$ZnSnS$_4$ selon l'invention qui est sensiblement exempte de composé carboné -notamment de thiourée et/ou de thiocyanate de potassium (KSCN) et des produits de dégradation de la thiourée et/ou du KSCN ou de composés carbonés du type tensioactif (par exemple oléylamine)- et d'une grande stabilité vis-à vis de la décantation. Il est possible de renouveler l'opération d'élimination des impuretés résiduelles.

On obtient une dispersion colloïdale selon l'invention présentant une valeur, déterminée par analyse en mobilité électrophorétique de ladite dispersion colloïdale, de potentiel $\zeta$, dit potentiel zéta, de charge qui est négative et de valeur absolue supérieure à 30 mV.

On réalise une acquisition d'un spectre RMN du solide $^{119}$Sn avec un spectromètre Brucker AV400 par rotation à l'angle magique à la fréquence de l'étain 149.01 MHz. Les conditions d'acquisition d'un spectre correspondent à une irradiation de l'échantillon sous un pulse de π/2 (4μs) une fréquence de rotation du rotor de 6 KHz, des intervalles de temps entre chaque acquisition de 30 s et un nombre d'accumulations de 1600. On réalise une telle acquisition pour un matériau CZTS non modifié selon l'invention. On observe un signal de résonance dans la gamme des déplacements chimiques (δ) comprise entre -180 ppm et -120 ppm. Ce signal de résonance est attribuable aux particules de CZTS non modifiées en surface. On réalise aussi une telle acquisition pour un matériau à l'état divisé selon l'invention, c'est-à-dire obtenues par traitement de particules CZTS par des clusters inorganiques. On observe des signaux de résonance supplémentaires dans la gamme des déplacements chimiques (δ) comprise entre -350 ppm et -700 ppm.

Il a été analysé que ce déplacement chimique ne correspond ni au déplacement chimique du $SnS_2$ décrit à δ = -760 ppm ni au déplacement chimique du SnS décrit à δ = -299 ppm (J. Solid. Stat. Chem., (2003), 175, 359-365).

On applique la dispersion colloïdale stable sur une surface solide -notamment sur une surface extérieure d'un matériau d'électrode de cellule solaire- de façon à former un film de ladite dispersion colloïdale d'épaisseur comprise entre 0,1 μm et 5 μm -notamment de l'ordre de 2 μm-. On réalise une telle application par des procédés nécessitant la mise en oeuvre de dispersions colloïdales concentrées et connus en eux-mêmes, par exemple par coulage en bande ou par un procédé de trempage (« dip-coating »).

Après séchage du film de ladite dispersion colloïdale, on réalise une étape de densification par frittage dudit film sous atmosphère d'un gaz inerte, d'une composition d'un gaz inerte comprenant une pression partielle de sélénium, ou sous pression réduite d'un gaz inerte à une température comprise entre 400°C et 600°C.

EXEMPLE 1 - Fabrication d'un matériau à l'état divisé à base de Cu, Zn, Sn, S et clusters inorganique

On prépare une composition de poudres comprenant 0,674 g de chlorure de cuivre(I) (CuCl 2H_2O, PROLABO, France, 6,82 mmoles), 0,465 g de chlorure de zinc(II) ($ZnCl_2$, ALDRICH, France, 3,41 mmoles), 1,19 g de chlorure d'étain(IV) ($SnCl_4$ $5H_2O$, ACROS, France, 3,41 mmoles). On dissout cette composition de poudres dans 20 mL d'alcool éthylique. On évapore cette solution éthanolique sous vide de façon à former une pâte visqueuse. On ajoute à cette pâte visqueuse 4,97 g de thiocyanate de potassium (K-S-C=N, FLUKA ALDRICH, France, 51,15 mmoles). On place cette pâte visqueuse dans un mélangeur (Analog Vortex mixer, VWR, France) de façon à former un mélange homogène présentant des proportions molaires en (Cu, Zn, Sn, S) de (2, 1, 1, 15).

On transfère cette pâte visqueuse dans un creuset en pyrex que l'on place dans l'enceinte d'un four sous atmosphère contrôlée d'azote ($N_2$). On chauffe le creuset jusqu'à la valeur de 400°C en 6 h. On maintient, toujours sous azote, la température de 400°C dans l'enceinte du four pendant 16 heures. Après déclin thermique du creuset, on ajoute 200 mL d'eau au solide obtenu dans le creuset et on soumet le mélange à un traitement aux ultrasons pendant une durée de 60 min de façon à dissoudre thiocyanate de potassium en excès. On sépare le solide et la solution liquide de thiocyanate de potassium par centrifugation à 1700 g pendant 20 min. On lave deux fois le solide avec 200 mL d'alcool éthylique. On obtient un solide de couleur noire que l'on sèche à température ambiante.

On répète cette synthèse quatre fois à l'identique, on regroupe et on sèche à température ambiante les solides obtenus pendant une durée de 48 h.

Le spectre de diffraction des rayons X de la poudre obtenue est caractéristique d'une structure cristalline unique $Cu_2ZnSnS_4$.

Broyage du matériau solide

On place 9 g du solide cristallisé tel qu'obtenu ci-dessus à l'exemple 1, 60 g de billes de broyage ($ZrO_2$-$Y_2O_3$) de granulométrie de l'ordre de 0,3 mm et 20 mL d'alcool éthylique dans le réceptacle d'un broyeur à attrition. On soumet cette préparation à un traitement par broyage pendant une durée de 5 h à la température ambiante. On sépare par filtration sur tamis les billes de broyage et le matériau à l'état divisé en suspension dans l'alcool éthylique. On lave les billes de broyage plusieurs fois à l'alcool éthylique. Le volume d'alcool éthylique contenant le matériau à l'état divisé est de 1500 mL. On réalise une centrifugation de cette suspension à 1470 g pendant 20 min, on élimine l'alcool éthylique surnageant et on reprend le culot formé du matériau à l'état divisé dans 1500 mL d'eau distillée. On traite la suspension sous agitation aux ultrasons pendant une durée de 5 min de façon à former une suspension aqueuse du matériau à l'état divisé.

On soumet la suspension aqueuse ainsi obtenue à une étape de centrifugation à 1700 g pendant 20 min. On élimine le surnageant limpide obtenu et on disperse à nouveau le solide obtenu dans 1500 mL d'eau distillée sous agitation et sous ultrasons pendant une durée de 5 min.

On soumet la nouvelle suspension aqueuse ainsi obtenue à une étape de centrifugation à 1700 g pendant 20 min. On élimine le surnageant limpide obtenu et on disperse à nouveau le solide obtenu dans 1500 mL d'eau distillée sous agitation et sous ultrasons pendant une durée de 5 min.

On soumet la dispersion à une étape de centrifugation à 1700 g pendant 20 min de façon à former une suspension colloïdale ($S_1$) de coloration noire et un culot que l'on redisperse dans 1500 mL d'eau. Par lavages à l'eau et et centrifugations successives, on forme des suspensions colloïdales (S$_2$, S$_3$, S$_4$) que l'on regroupe pour former une suspension colloïdale S$_5$.

Préparation d'une solution de clusters inorganiques Zn / Sn ; 0,66/0,33

Dans un bécher, on place 61,91 mL d'une solution hydroalcoolique de (NH$_4$)$_2$S à 20% (d = 1,1, 3,23 M) de façon à former une solution à 0,20 M dans l'eau distillée. On dissout 4,56 g de ZnCl$_2$ (PM 136,4, soit 33 mmoles de Zn) et 6,02 g de SnCl$_4$ 5H$_2$O (PM 350,7, soit 17 mmoles de Sn) dans un 200 mL d'une solution aqueuse d'acide chlorhydrique 0,2 M. On complète à 250 mL par addition d'une solution de HCl 0,2M. Le rapport molaire Zn / Sn du sel inorganique est de 2. Le rapport molaire H$^+$/[Zn+Sn] est de 1,0. On ajoute de manière instantanée la solution (Zn ; Sn) dans la solution aqueuse de (NH$_4$)$_2$S. On obtient une solution visuellement limpide au bout de 8 heures et dont le pH est égal à 9,46 contenant les clusters inorganiques. Le rapport molaire S / (Zn + Sn) est égal à 4.

Modification de surface des particules Cu$_2$ZnSnS$_4$

On soumet la suspension colloïdale S$_5$ de particules Cu$_2$ZnSnS$_4$ obtenue ci-dessus à une centrifugation à 1700 g de façon à former un culot humide. On met le culot humide en contact avec 40 mL de la solution de clusters inorganiques sous agitation pendant 1 heure, puis en contact pendant 2 h à température ambiante. On centrifuge la suspension à 15000 g pendant 20 min. On élimine le surnageant et on met à nouveau le culot en contact avec 40 mL de la solution de clusters inorganiques sous agitation pendant 1 heure, puis en contact pendant 16 h à température ambiante. On centrifuge la suspension à 15000 g pendant 20 min. On élimine le surnageant et on met le culot en contact avec 40 mL d'une solution de (NH$_4$)$_2$S 0,01 M. On répète l'étape de traitement à 40 mL de solution de (NH$_4$)$_2$S 0,01 M. La concentration de la dispersion colloïdale est de 40 g/L en Cu$_2$ZnSnS$_4$.

L'examen par microscopie électronique à transmission montre des particules parfaitement individualisées de taille moyenne de l'ordre de 15 nm (figure 1).

Le potentiel zéta mesuré de la dispersion colloïdale selon l'invention est de -46 mV.

Matériau à l'état divisé selon l'invention redispersable dans l'eau

On lyophilise la dispersion colloïdale à 40 g/L obtenue ci-dessus à la température de -40°C et sous pression réduite de 0,1 hPa. On obtient un matériau à l'état divisé formé d'une poudre de particules solides de coloration noire. L'analyse par diffraction des rayons X réalisée sur cette poudre montre une structure unique Cu$_2$ZnSnS$_4$. La spectroscopie de la poudre dispersée dans du bromure de potassium (KBr) montre des raies centrées à 1410 cm$^{-1}$ et à 1600 cm$^{-1}$. La spectroscopie Raman révèle un signal à une valeur de nombre d'onde de l'ordre de 336 cm$^{-1}$ et une largeur de raie de 22 cm$^{-1}$.

On ajoute un volume d'eau déminéralisée à 100 mg de la poudre lyophilisée de façon à former un volume de suspension de 2 mL. On obtient une suspension colloïdale selon l'invention qui est stable dans le temps et qui présente une concentration de 50 g/L en Cu$_2$ZnSnS$_4$.

EXEMPLE 2 - Fabrication d'une dispersion colloïdale d'un matériau à l'état divisé selon l'invention à base de Cu, Zn, Sn, S formé de particules poly-cristallines et clusters inorganique Zn ; Sn de stoechiométrie 0,66 ; 0,33.

Dans 200 mL d'éthylène glycol, on introduit 1.73 g de chlorure d'étain(IV) hydraté (SnCl$_4$ 5H$_2$O, soit 4.95 mmoles), 0.8 g de chlorure de zinc(II) (ZnCl$_2$, 5.85 mmoles) et 1,534 g de chlorure de cuivre(II) (CuCl$_2$-2H$_2$O, 9 mmoles). On maintient la suspension des sels métalliques ainsi formée sous agitation à température ambiante jusqu'à complète dissolution desdits sels métalliques dans l'éthylène glycol. On ajoute ensuite à la solution de Sn(IV), Cu(II) et Zn(II), 3.42 g de thio-urée CS(NH$_2$)$_2$, (FLUKA ALDRICH, France, 45 mmoles) et on maintient l'agitation de ladite solution pendant 10 min à température ambiante. On ajoute ensuite sous agitation et à température ambiante, 3.645 mL d'une solution d'hydroxyde de tétraméthylammonium (TMaOH) à 25 % (soit 9 mM) dans le méthanol et on laisse sous agitation pendant 30 min. On complète la solution à 300 mL par de l'éthylène glycol et on laisse le mélange sous agitation pendant 20 min supplémentaires. Les proportions molaires (Cu ; Zn ; Sn ; S ; OH) dans la solution sont (2 ; 1,3 ; 1,1 ; 10 ; 2).

On place ce mélange dans un creuset en téflon que l'on dispose dans un autoclave (bombe de Parr) non agité et placé dans une étuve à la température de 200°C pendant 16 h. L'autoclave est ensuite refroidit par déclin thermique naturel jusqu'à la température ambiante.

On obtient un précipité que l'on sépare de la solution liquide des eaux-mères par centrifugation à 1720 g pendant 20 min à la température ambiante. On lave le précipité avec 300 mL d'eau et on récupère le précipité par centrifugation à 1720 g pendant 20 min à la température ambiante. On répète trois fois cette opération de lavage à l'eau du précipité. On rince dans l'alcool éthylique le précipité que l'on récupère par centrifugation.

On reproduit une fois à l'identique la synthèse décrite ci-dessus à l'exemple 1 et on collecte les deux précipités obtenus. Après séchage à température ambiante pendant 48 h, on pèse le précipité (m = 4 g).

Broyage du précipité

On place le précipité obtenu ci-dessus à l'exemple 2 (4 g), 32 g de billes de broyage (granulométrie de l'ordre de 0,3 mm) formées de $ZrO_2$-$Y_2O_3$ et 10 mL d'alcool éthylique dans le réceptacle d'un broyeur à attrition. On soumet cette préparation à un traitement broyage pendant une durée de 4 heures à la température ambiante. On rajoute 10 mL d'alcool éthylique et on poursuit le broyage pendant une durée supplémentaire de 4 heures. On place la suspension du matériau broyé ainsi obtenu sous agitation pendant environ 12 heures en présence des billes de broyage, puis on sépare par filtration les billes de broyage et la suspension dudit matériau broyé.

On réalise une pluralité de lavages des billes de broyage dans l'alcool éthylique et on sépare par filtration les billes de broyage et les suspensions de lavage du matériau broyé. On regroupe les suspensions contenant le matériau broyé obtenues par lavages successifs des billes de broyage pour former une suspension du matériau broyé dans l'alcool éthylique.

On réalise une centrifugation de cette suspension à 2080 g pendant 20 min, lors de laquelle on sépare un culot solide brut comprenant le matériau broyé et un surnageant liquide qui est éliminé.

On reprend et on suspend le culot solide brut obtenu dans 600 mL d'alcool éthylique, on traite la suspension alternativement par les ultrasons et par agitation magnétique et on centrifuge celle-ci à 1470 g pendant 10 min. On obtient culot résiduel et un surnageant coloré (marron/noir) formé d'une suspension du matériau broyé dans l'alcool éthylique. On répète deux fois successivement l'opération de lavage du culot résiduel.

On mélange les trois suspensions du matériau broyé (volume total 1800 mL) dans l'alcool éthylique. La concentration du matériau broyé à l'état divisé $Cu_2ZnSnS_4$ dans la suspension est de 0,8 g/L.

On réalise une analyse de la suspension en microscopie électronique à transmission après traitement de ladite suspension aux ultrasons, dépôt et séchage sur une membrane, lors de laquelle on visualise des nanoparticules individualisées de taille de l'ordre de 180 nm sous forme d'agrégats. Ces agrégats sont constitués de cristallites primaires de taille de l'ordre de 7 nm.

L'analyse par diffraction des rayons X des nanoparticules de la suspension montre un ensemble de raies attribuables à la structure $Cu_2ZnSnS_4$.

Les particules du matériau sont analysées après dispersion dans une résine par spectroscopie de dispersion d'énergie sous microscope électronique (grossissement de x2000) à balayage (EDS-MEB) sur 5 champs d'observation statistiquement représentatifs. Les rapports molaires Zn/Cu = 1 et Sn/Cu = 1 mesurés démontrent la composition stoechiométrique du matériau.

Préparation d'une solution de clusters inorganiques

On prépare une solution de clusters inorganiques Zn / Sn ; 0,66/0,33 comme décrit à l'exemple 1. On réalise une étape supplémentaire de purification des clusters inorganiques visant à éliminer le chlorure d'ammonium ($NH_4Cl$) résiduel dans laquelle on ajoute 300 mL d'acétone à 100 mL de la solution visuellement limpide de clusters inorganiques. Après 6 heures, la solution se trouble et forme un précipité qui est isolé par centrifugation à 15000 g. On reprend le précipité isolé avec 100 mL d'une solution aqueuse de $(NH_4)_2S$ à 0,01 M. Après dissolution complète du précipité, on ajoute 600 mL d'acétone. Le précipité formé au bout de 6 heures est récupéré par centrifugation à 15000 g. On élimine le surnageant et on reprend le culot de centrifugation avec 50 mL de $(NH_4)_2S$ à 0,01 M.

Modification de surface des particules $Cu_2ZnSnS_4$

On met en contact 1,78 g de particules $Cu_2ZnSnS_4$ obtenue ci-dessus à l'exemple 2 et 30 mL de la solution de clusters inorganiques à pH 9,23 telle que purifiée ci-dessus sous agitation pendant une durée de 15 min. On complète le mélange à 80 mL avec une solution aqueuse $(NH_4)_2S$ à 0,01 M et on maintient l'incubation à température ambiante pendant 2 heures.

On centrifuge la dispersion de particules, on élimine le surnageant et on reprend le culot avec 30 mL de la solution de clusters inorganiques à pH 9,23. Après agitation pendant une durée de 15 min, on complète le mélange à 80 mL avec une solution aqueuse $(NH_4)_2S$ à 0,01 M et on maintient à nouveau l'incubation à température ambiante pendant 2 heures. On centrifuge la dispersion, on élimine le surnageant et on reprend le culot avec 70 mL de solution aqueuse $(NH_4)_2S$ à 0,01 M. On obtient une dispersion colloïdale selon l'invention à une concentration de 25 g/L. La dispersion colloïdale est stable dans le temps vis-à-vis de la décantation.

Le potentiel zéta mesuré de la dispersion colloïdale selon l'invention est de -37 mV.

Matériau à l'état divisé selon l'invention redispersable dans l'eau

On sèche par lyophilisation la dispersion colloïdale à 25 g/L obtenue ci-dessus à la température de -40°C et sous pression réduite de 0,1 hPa. On obtient un matériau à l'état divisé formé d'une poudre de particules solides de coloration noire. On ajoute 70 mL d'eau déminéralisée au matériau à l'état divisé. On obtient une suspension colloïdale selon l'invention qui est stable dans le temps.

EXEMPLE 3 - Fabrication d'une dispersion colloïdale d'une poudre de particules à base de Cu, Zn, Sn, S monocristallines modifiées en surface par des clusters inorganiques.

Dans 200 mL d'éthylène glycol, on introduit 1.73 g de chlorure d'étain(IV) hydraté ($SnCl_4$ $5H_2O$, soit 4.95 mmoles), 0.8 g de chlorure de zinc(II) ($ZnCl_2$, 5.85 mmoles) et 1,534 g de chlorure de cuivre(II) ($CuCl_2$-$2H_2O$, 9 mmoles). On maintient la suspension des sels métalliques ainsi formée sous agitation à température ambiante jusqu'à complète dissolution desdits sels métalliques dans l'éthylène glycol. On ajoute ensuite à la solution de Sn(IV), Cu(II) et Zn(II), 3.42 g de thio-urée $CS(NH_2)_2$, (FLUKA ALDRICH, France, 45 mmoles) et on maintient l'agitation de ladite solution pendant 10 min à température ambiante. On ajoute ensuite sous agitation et à température ambiante, 3.645 mL d'une solution d'hydroxyde de tétraméthylammonium (TMaOH) à 25 % (soit 9 mM) dans le méthanol MeOH et on laisse sous agitation pendant 30 min. On ajoute 1,584 g d'acide ascorbique ($C_6H_8O_6$, ALDRICH, France, 9 mmoles). On complète la solution à 300 mL par de l'éthylène glycol et on laisse le mélange sous agitation pendant 20 min supplémentaires. Les proportions molaires (Cu ; Zn ; Sn ; S ; OH ; Asc) dans la solution sont (2 ; 1,3 ; 1,1 ; 10 ; 2 ; 2).

On place ce mélange dans un creuset en téflon que l'on dispose dans un autoclave (bombe de Parr) non agité et placé dans une étuve à la température de 200°C pendant 16 h. L'autoclave est ensuite refroidit par déclin thermique naturel jusqu'à la température ambiante.

On obtient un précipité que l'on sépare de la solution liquide des eaux-mères par centrifugation à 1720 g pendant 20 min à la température ambiante. On lave le précipité avec 300 mL d'eau et on récupère le précipité par centrifugation à 1720 g pendant 20 min à la température ambiante. On répète trois fois cette opération de lavage à l'eau du précipité. On rince dans l'alcool éthylique le précipité que l'on récupère par centrifugation.

On reproduit une fois à l'identique la synthèse décrite ci-dessus à l'exemple 8 et on collecte les deux précipités obtenus. Après séchage à température ambiante pendant 48 h, on pèse le précipité (m = 4 g).

Broyage du matériau solide

On place le précipité obtenu ci-dessus (4 g), 32 g de billes de broyage (granulométrie de l'ordre de 0,3 mm) formées de $ZrO_2$-$Y_2O_3$ et 10 mL d'alcool éthylique dans le réceptacle d'un broyeur à attrition. On soumet cette préparation à un traitement broyage pendant une durée de 4 heures à la température ambiante. On rajoute 10 mL d'alcool éthylique et on poursuit le broyage pendant une durée supplémentaire de 4 heures. On place la suspension du solide broyé sous agitation pendant 12 heures en présence des billes de broyage, puis on sépare par filtration les billes de broyage et la suspension dudit matériau solide.

On réalise une pluralité de lavages des billes de broyage dans l'alcool éthylique et on sépare par filtration les billes de broyage et les suspensions de lavage du matériau solide. On regroupe les suspensions contenant le matériau solide obtenues par lavages successifs des billes de broyage pour former une suspension du matériau solide dans l'alcool éthylique.

On réalise une centrifugation de cette suspension à 2080 g pendant 20 min, lors de laquelle on sépare un culot solide brut comprenant le matériau solide et un surnageant liquide qui est éliminé.

On reprend et on suspend le culot solide brut obtenu dans 600 mL d'alcool éthylique, on traite la suspension alternativement par les ultrasons et par agitation magnétique et on centrifuge celle-ci à 1470 g pendant 10 min. On obtient culot résiduel et un surnageant coloré (marron/noir) formé d'une suspension du matériau solide selon l'invention dans l'alcool éthylique. On répète deux fois successivement l'opération de lavage du culot résiduel.

On mélange les trois suspensions du matériau solide (volume total 1800 mL) dans l'alcool éthylique. La concentration du matériau solide à l'état divisé $Cu_2ZnSnS_4$ dans la suspension est de 0,8 g/L. La suspension stockée en flacons étanches est stable vis à vis de la décantation sur plus de 4 jours. On laisse évaporer à température ambiante la suspension obtenue de façon à former un solide cristallisé.

Traitement thermique en sels fondus

On mélange 0,5 g de la poudre de particules ($Cu_2$ ; Zn ; Sn ; $S_4$) obtenue ci-dessus avec 3,0 g de KSCN. La proportion molaire (S)/(Cu) dans le mélange est de 6. Le mélange, placé dans un creuset en alumine, est introduit dans une enceinte sous atmosphère d'azote à la température ambiante. On chauffe l'enceinte de façon que sa température augmente régulièrement et atteigne 500°C en 150 min, puis on maintient cette température de 500°C dans l'enceinte pendant 6 h. Après refroidissement naturel de l'enceinte, on reprend la poudre calcinée dans 200 mL d'eau déminéralisée et on homogénéise la suspension par agitation magnétique pendant 30 min de façon que le KSCN résiduel passe en solution dans l'eau. On centrifuge la suspension ainsi obtenue à 1700 g pendant 20 min, on élimine le surnageant et on reprend le solide obtenu avec 200 mL d'eau déminéralisée par homogénéisation pendant 20 min. On forme une suspension (S1).

Sélection de particules (fines) de petite dimension

On centrifuge la suspension (S1) obtenue à 1720 g pendant 20 min de façon à former un culot solide (C1) et une dispersion (D1) colorée qui est soumise à une centrifugation à 8000 g pendant 20 min pour la récupération des particules fines. La fraction solide de centrifugation à 8000 g constitue la fraction fine F1.

On reprend et on disperse le culot solide (C1) dans 160 mL d'eau distillée par agitation magnétique pendant 20 min pour former une suspension (S2). Par centrifugation de la suspension (S2) à 1720 g pendant 20 min, on forme une dispersion (D2) colorée qui est soumise à une étape de centrifugation à 8000 g pendant 20 min. La fraction solide de centrifugation à 8000 g constitue la fraction fine F2.

On répète l'étape de sélection des particules de petite dimension et on obtient une deuxième fraction fine F3. On collecte les fractions fines F1, F2 et F3 qui constituent un matériau cristallisé.

Préparation d'une solution de clusters inorganiques

On met en contact 0,3 g de particules formant le matériau cristallisé obtenu à l'exemple 3 et 3,4 mL de la solution de clusters inorganiques telle que préparée à l'exemple 1. Le rapport molaire (Zn + Sn) dans la solution de sels inorganiques et de Zn dans le matériau cristallisé est de 0,5. On dilue ensuite le mélange avec une solution aqueuse de $(NH_4)_2S$ 0,01 M jusqu'à obtenir un volume de suspension de 7,5 mL et on laisse en contact à température ambiante pendant 2 h.

On centrifuge la suspension à 1700 g pendant 20 min et on renouvelle l'étape de contact des particules de matériau cristallisé avec 3,4 mL de la solution de clusters inorganiques. On laisse sous agitation pendant 1 h, puis on complète le volume à 7,5 mL avec une solution aqueuse de $(NH_4)_2S$ 0,01 M. On laisse en contact à température ambiante pendant 16 h.

On centrifuge la suspension à 1700 g pendant 20 min, on élimine le surnageant et on disperse le culot dans 7,5 mL de solution aqueuse de $(NH_4)_2S$ 0,01 M. On laisse sous agitation pendant 1 h et on centrifuge à 15000 g pendant 20 min. Le culot de particules est redispersé et lavé dans 7,5 mL de solution aqueuse de $(NH_4)_2S$ 0,01 M. Après centrifugation à 15000 g, puis élimination du surnageant, le culot est repris dans un volume de la solution aqueuse de $(NH_4)_2S$ 0,01 M de façon à former une dispersion colloïdale selon l'invention à une concentration de 25 g/L.

Matériau à l'état divisé selon l'invention redispersable dans l'eau

On sèche par lyophilisation la dispersion colloïdale à 25 g/L obtenue ci-dessus à la température de -40°C et sous pression réduite de 0,1 hPa. On obtient un matériau à l'état divisé formé d'une poudre de particules solides de coloration noire.

L'analyse par diffraction des rayons X réalisée sur cette poudre montre une structure unique $Cu_2ZnSnS_4$. La spectroscopie de la poudre dispersée dans du bromure de potassium (KBr) montre des raies centrées à 1410 cm$^{-1}$ et à 1600 cm$^{-1}$. La spectroscopie Raman révèle un signal à une valeur de nombre d'onde de l'ordre de 336 cm$^{-1}$ et une largeur de raie de 20 cm$^{-1}$.

On ajoute un volume d'eau déminéralisée à 100 mg de la poudre lyophilisée de façon à former un volume de suspension de 4 mL. On obtient une suspension colloïdale selon l'invention qui est stable dans le temps et qui présente une concentration de 25 g/L en $Cu_2ZnSnS_4$.

**Revendications**

**1.** Matériau à l'état divisé formé de particules solides de composition générale (A) suivante :

$$(Cu^{+1}_2 ; Zn^{+2}_{a-v-(y/2)} ; Cd^{+2}_v ; Sn^{+4}_{b-w-(y/2)} ; {}^1X^{+4}_w ; {}^2X^{+3}_y ; S^{-2}_{c-x} ; Se^{-2}_x) \qquad (A),$$

où ;

   *a, b, c, v, w, x* et *y* et leur combinaisons arithmétiques sont des nombres réels qui représentent la proportion molaire de chaque élément auquel chaque nombre est associé dans la formule (A), et tels que :

   ∘ $1 \le a < 1{,}65$ ;
   ∘ $1 \le b < 1{,}40$ ;

○ 4 < $c$ < 9, et ;

o v, w, x et y appartiennent indépendamment les uns des autres à l'ensemble des nombre réels appartenant à l'intervalle [0 ; 0,5[, et,

- $^1X^{+4}$ est choisi dans le groupe formé des cations du titane (Ti), des cations du zirconium (Zr) et des cations du plomb (Pb),
- $^2X^{+3}$ est choisi dans le groupe formé des cations du gallium (Ga), des cations de l'indium (In) et des cations de l'yttrium (Y) ;

ledit matériau présentant :

- par analyse dudit matériau par diffraction des rayons X, une structure cristalline unique ;
- par analyse élémentaire, une proportion massique d'élément carbone inférieure à 2,5%.

2. Matériau selon la revendication 1, **caractérisé en ce qu'**il est adapté pour pouvoir former une dispersion colloïdale dudit matériau à l'état divisé dans une phase liquide aqueuse choisie dans le groupe formé des solutions aqueuses et des solutions mixtes d'eau et d'au moins un solvant miscible dans l'eau.

3. Matériau selon l'une des revendications 1 ou 2, **caractérisé en ce que** les particules solides du matériau à l'état divisé présentent :

- un diamètre équivalent moyen compris entre 15 nm et 350 nm, et ;
- au moins un domaine, dit domaine cristallin, de taille moyenne, mesurée par diffraction des rayons X, comprise entre 3 nm et 100 nm, ledit domaine cristallin présentant une structure cristalline unique.

4. Matériau selon l'une des revendications 1 à 3, caractérisé en ce les particules solides du matériau à l'état divisé présentent, par spectroscopie Raman, une raie de diffusion, dite raie primaire, présentant une intensité maximum de diffusion à une valeur de nombre d'onde comprise entre 310 cm$^{-1}$ et 340 cm$^{-1}$.

5. Dispersion colloïdale d'un matériau à l'état divisé selon la revendication 1 dans une phase liquide aqueuse choisie dans le groupe formé des solutions aqueuses, et des solutions mixtes d'eau et d'au moins un solvant miscible dans l'eau ;

la dispersion colloïdale présentant une concentration du matériau à l'état divisé dans ladite dispersion colloïdale supérieure à 20 g/L ;

la dispersion colloïdale présentant une valeur, déterminée par analyse en mobilité électro-phorétique de ladite dispersion, de potentiel $\zeta$, dit potentiel zéta, de charge qui est négative et de valeur absolue supérieure à 20 mV.

6. Dispersion colloïdale selon la revendication 5, **caractérisée en ce que** les particules solides du matériau à l'état divisé présentent un diamètre équivalent moyen compris entre 15 nm et 350 nm.

7. Dispersion colloïdale selon l'une des revendications 5 à 7, **caractérisée en ce que** le matériau à l'état divisé présente au moins un domaine, dit domaine cristallin, de taille moyenne, mesurée par diffraction des rayons X, comprise entre 3 nm et 100 nm, ledit domaine cristallin présentant la structure cristalline unique.

8. Dispersion colloïdale selon l'une des revendications 5 à 7, **caractérisée en ce qu'**elle est adaptée pour que plus de 50% en poids du matériau à l'état divisé reste en suspension dans la dispersion colloïdale après un traitement par centrifugation de ladite dispersion colloïdale sous une accélération de 1250 g pendant une durée de 10 min.

9. Dispersion colloïdale selon l'une des revendications 5 à 8, **caractérisée en ce que** le solvant miscible dans l'eau est choisi dans le groupe formé des alcools et de l'acétonitrile.

10. Dispersion colloïdale selon l'une des revendications 5 à 9, **caractérisée en ce que** les particules solides du matériau à l'état divisé présentent, par spectroscopie Raman, une raie de diffusion, dite raie primaire, présentant une intensité maximum de diffusion à une valeur de nombre d'onde comprise entre 310 cm$^{-1}$ et 340 cm$^{-1}$, ladite raie primaire présentant une largeur de raie à mi-hauteur comprise entre 5 cm$^{-1}$ et 60 cm$^{-1}$.

11. Dispersion colloïdale selon l'une des revendications 5 à 10, **caractérisée en ce que** le matériau à l'état divisé présente, par analyse en spectrométrie infra-rouge, au moins une bande d'absorption présentant une valeur maximale d'intensité d'absorption à une valeur de nombre d'onde comprise entre 1390 cm$^{-1}$ et 1420 cm$^{-1}$ et une valeur maximale d'intensité d'absorption à une valeur de nombre d'onde comprise entre 1590 cm$^{-1}$ et 1625 cm$^{-1}$.

**12.** Dispersion colloïdale selon l'une des revendications 5 à 11, **caractérisée en ce que** la phase liquide aqueuse comprend au moins un soluté choisi dans le groupe formé du $(NH_4)_2S$, du $Sn_2S_6(NH_4)_4$, des complexes métalliques à base de Zn, de Sn, de Ga et d'In et des nanoparticules à base de Zn et de Sn dans une proportion massique dans la phase liquide aqueuse inférieure à 10% de la masse sèche totale de la dispersion colloïdale.

**13.** Procédé de préparation d'une dispersion colloïdale selon l'une des revendications 5 à 12 dans lequel :

- on prépare une solution aqueuse de sels de cations métalliques choisis dans le groupe formé du $Zn^{2+}$, du $Sn^{2+}$, du $Sn^{4+}$, du $Cd^{2+}$, du $In^{3+}$, du $Ga^{3+}$ et du $Y^{3+}$ et d'au moins un acide minéral, la concentration molaire des cations métalliques dans la solution aqueuse étant comprise entre 0,05 mol/L et 0,5 mol/L puis ;
- on prépare une solution, dite solution de sulfure, aqueuse ou hydroalcoolique d'au moins un sulfure choisi dans le groupe formé de $Na_2S$ et de $(NH_4)_2S$, puis ;
- on réalise au moins une étape d'addition de la solution aqueuse de sels de cations métalliques dans la solution de sulfure de façon à former une solution de complexes de sulfures métalliques, dits cluster inorganique, puis ;
- on met en contact et on incube :

 o une quantité de la solution de cluster inorganique ;
 o une quantité de particules présentant :

  ■ par diffraction des Rayons X une structure cristalline $Cu_2 Zn Sn S_4$ du type Kestérite ou Kestérite dopée, et ;
  ■ un diamètre équivalent moyen compris entre 15 nm et 350 nm ;

 o éventuellement, une quantité d'une solution aqueuse d'au moins un sulfure à une concentration comprise entre 0,01 mol/L et 1 mol/L ;

- on réalise une étape de séparation -notamment par centrifugation- des particules solides et de la solution aqueuse ;
- on disperse le culot avec une solution aqueuse ou hydroalcoolique contenant éventuellement au moins un sulfure du type $(NH_4)_2S$, de façon à former une suspension colloïdale d'un matériau à l'état divisé dans une phase liquide aqueuse, le matériau à l'état divisé présentant, par analyse élémentaire, une proportion massique en élément carbone inférieure à 2,5%,
la dispersion colloïdale présentant une concentration du matériau à l'état divisé dans ladite dispersion colloïdale supérieure à 20 g/L.

**14.** Utilisation d'une dispersion colloïdale selon l'une des revendications 5 à 12 pour la fabrication d'un film photo-absorbant d'une cellule photovoltaïque, dans laquelle :

- on place une quantité de ladite dispersion colloïdale sur un support solide de façon à former un film de ladite dispersion colloïdale s'étendant en surface dudit support et d'épaisseur comprise entre 0,1 $\mu$m et 5 $\mu$m, puis ;
- on réalise une étape de traitement par frittage dudit film sous atmosphère de Se.

**Patentansprüche**

**1.** Material im zerteilten Zustand gebildet aus festen Teilchen der folgenden allgemeinen Zusammensetzung (A):

$$(Cu^{+1}_2; Zn^{+2}_{a-v-(y/2)}; Cd^{+2}_v; Sn^{+4}_{b-w-(y/2)}; {}^1X^{+9}_w; {}^2X^{+3}_y; S^{-2}_{c-x}; Se^{-2}_x) \qquad (A),$$

wobei;

$a, b, c, v, w, x$ und $y$ und arithmetische Kombinationen davon reelle Zahlen sind, die das Molverhältnis jedes Elements darstellen, dem jede Zahl in der Formel (A) zugeordnet ist, und wie:

- $1 \leq a < 1{,}65$;

- $1 \leq b < 1,40$;
- $4 < c < 9$, und;
- *v, w, x* und *y* gehören unabhängig voneinander zur Menge der reellen Zahlen, die zum Intervall [0; 0,5[ gehören, und,
- $^{-1}X^{+4}$ ist ausgewählt aus der Gruppe, bestehend aus Titankationen (Ti), Zirkoniumkationen (Zr) und Bleikationen (Pb),
- $^{-2}X^{+3}$ ist ausgewählt aus der Gruppe, bestehend aus Galliumkationen (Ga), Indiumkationen (In) und Yttriumkationen (Y);

wobei das besagte Material aufweist:

--- durch Analyse des besagten Materials durch Röntgendiffraktion, eine einzigartige kristalline Struktur;
--- durch Elementaranalyse, einen Massenanteil des Kohlenstoffelements kleiner als 2,5 %;

2. Material nach Anspruch 1, **dadurch gekennzeichnet, dass** es ausgelegt ist zur Bildung einer kolloidalen Dispersion aus dem besagten Material im zerteilten Zustand in einer wässrigen Flüssigphase ausgewählt aus der Gruppe, bestehend aus wässrigen Lösungen und aus gemischten Lösungen aus Wasser und mindestens einem mit Wasser mischbaren Lösungsmittel.

3. Material nach einem der Ansprüche 1 oder 2, **dadurch gekennzeichnet, dass** die festen Teilchen des Materials im geteilten Zustand aufweisen:

--- einen mittleren äquivalenten Durchmesser zwischen 15 nm und 350 nm, und;
--- mindestens einen Bereich, genannt kristalliner Bereich, von mittlerer Größe, gemessen durch Röntgendiffraktion, zwischen 3 nm bis 100 nm, wobei der besagte kristalline Bereich eine einzigartige kristalline Struktur aufweist.

4. Material nach einem der Ansprüche 1 bis 3, **dadurch gekennzeichnet, dass** die festen Teilchen des Materials im geteilten Zustand, durch Raman-Spektroskopie, eine Diffusionslinie, genannt primäre Linie, aufweisen, die eine maximale Diffusionsintensität mit einem Wellenzahlwert zwischen 310 cm$^{-1}$ und 340 cm$^{-1}$ aufweist.

5. Kolloidale Dispersion eines Materials im geteilten Zustand nach Anspruch 1 in einer wässrigen Flüssigphase ausgewählt aus der Gruppe, bestehend aus wässrigen Lösungen, und gemischten Lösungen aus Wasser und mindestens einem mit Wasser mischbaren Lösungsmittel;
wobei die kolloidale Dispersion eine Konzentration des Materials im geteilten Zustand in der besagten kolloidalen Dispersion größer als 20g/L aufweist;
wobei die kolloidale Dispersion einen Wert aufweist, bestimmt durch Analyse elektrophoretischer Mobilität der besagten Dispersion, des Potentials $\zeta$, genannt Zeta-Potential, der Ladung, die negativ ist und des Absolutwerts von größer als 20 mV.

6. Kolloidale Dispersion nach Anspruch 5, **dadurch gekennzeichnet, dass** die festen Teilchen des Materials im geteilten Zustand einen mittleren äquivalenten Durchmesser zwischen 15 nm et 350 nm aufweisen.

7. Kolloidale Dispersion nach einem der Ansprüche 5 bis 7, **dadurch gekennzeichnet, dass** das Material im geteilten Zustand mindestens einen Bereich aufweist, genannt kristalliner Bereich, von mittlerer Größe, gemessen durch Röntgendiffraktion, zwischen 3 nm und 100 nm, wobei der besagte kristalline Bereich die einzigartige kristalline Struktur aufweist.

8. Kolloidale Dispersion nach einem der Ansprüche 5 bis 7, **dadurch gekennzeichnet, dass** sie dafür ausgelegt ist, dass mehr als 50 Gew.-% des Materials im geteilten Zustand in der kolloidalen Dispersion nach einer Zentrifugalbehandlung der besagten kolloidalen Dispersion unter einer Beschleunigung von 1250 g während einer Dauer von 10 Min. in der Suspension verbleiben.

9. Kolloidale Dispersion nach einem der Ansprüche 5 bis 8, **dadurch gekennzeichnet, dass** das im Wasser mischbare Lösungsmittel ausgewählt ist aus der Gruppe, bestehend aus Alkoholen und Azetonitril.

10. Kolloidale Dispersion nach einem der Ansprüche 5 bis 9, **dadurch gekennzeichnet, dass** die festen Teilchen des Materials im geteilten Zustand, durch Raman-Spektroskopie, eine Diffusionslinie, genannt primäre Linie, aufweisen, die eine maximale Diffusionsintensität mit einem Wellenzahlwert zwischen 310 cm$^{-1}$ und 340 cm$^{-1}$ aufweist, wobei die besagte primäre Linie eine Linienbreite in halber Höhe zwischen 5 cm$^{-1}$ und 60 cm$^{-1}$ aufweist.

11. Kolloidale Dispersion nach einem der Ansprüche 5 bis 10, **dadurch gekennzeichnet, dass** das Material im geteilten Zustand, durch Infrarotspektroskopie-Analyse, mindestens eine Absorptionsbande aufweist, die einen maximalen Absorptionsintensitätswert mit einem Wellenzahlwert zwischen 1390 cm$^{-1}$ und 1420 cm$^{-1}$ und einen maximalen Absorptionsintensitätswert mit einem Wellenzahlwert zwischen 1590 cm$^{-1}$ und 1625 cm$^{-1}$ aufweist.

12. Kolloidale Dispersion nach einem der Ansprüche 5 bis 11, **dadurch gekennzeichnet, dass** die wässrige Flüssigphase mindestens einen gelösten Stoff umfasst, ausgewählt aus der Gruppe, bestehend aus $(NH_4)_2S$, $Sn_2S_6(NH_4)_4$, Metallkomplexen auf Basis von Zn, Sn, Ga und In und Nanopartikeln auf Basis von Zn und Sn in einem Massenanteil in der wässrigen Flüssigphase kleiner als 10% der Gesamttrockenmasse der kolloidalen Dispersion.

13. Verfahren zur Herstellung einer kolloidalen Dispersion nach einem der Ansprüche 5 bis 12, wobei:

--- eine wässrige Lösung aus Metallkation-Salzen zubereitet wird, ausgewählt aus der Gruppe, bestehend aus $Zn^{2+}$, $Sn^{2+}$, $Sn^{4+}$, $Cd^{2+}$, $In^{3+}$, $Ga^{3+}$ und $Y^{3+}$ und mindestens einer Mineralsäure, wobei die molare Konzentration der Metallkationen in der wässrigen Lösung zwischen 0,05 mol/L und 0,5 mol/L liegt, dann;
--- eine Lösung zubereitet wird, genannt Sulfidlösung, wässrig oder wässrig-alkoholisch mit mindestens einem Sulfid, ausgewählt aus der Gruppe, bestehend aus $Na_2S$ und $(NH_4)_2S$, dann;
--- mindestens ein Schritt der Zugabe der wässrigen Lösung der Metallkationen-Salze in die Sulfidlösung durchgeführt wird, um eine Lösung aus Metallsulfidkomplexen, genannt anorganischer Cluster, zu bilden, dann;
--- Folgendes in Kontakt gebracht und inkubiert wird:

- eine Menge der Lösung des anorganischen Clusters;
- eine Menge der Teilchen, die:

-- eine durch Röntgendiffraktion kristalline Struktur $Cu_2ZnSnS_4$ vom Typ eines Kesterits oder eines dotierten Kesterits, und;
-- einen mittleren äquivalenten Durchmesser zwischen 15 nm und 350 nm aufweisen;

- gegebenenfalls, eine Menge einer wässrigen Lösung aus mindestens einem Sulfid in einer Konzentration zwischen 0,01 mol/L und 1 mol/L;

--- ein Schritt der Trennung -insbesondere durch Zentrifugation- der festen Teilchen und der wässrigen Lösung durchgeführt wird;
--- der Stoff mit einer wässrigen oder wässrigalkoholischen Lösung dispergiert wird, die gegebenenfalls mindestens ein Sulfid vom Typ $(NH_4)_2S$ enthält, um eine kolloidale Suspension eines Materials im geteilten Zustand in einer wässrigen Flüssigphase zu bilden, wobei das Material im geteilten Zustand, durch Elementaranalyse, einen Massenanteil des Kohlenstoffelements kleiner als 2,5 % aufweist,
wobei die kolloidale Dispersion eine Konzentration des Materials im geteilten Zustand in der besagten kolloidalen Dispersion größer als 20 g/L aufweist.

14. Verwendung einer kolloidalen Dispersion nach einem der Ansprüche 5 bis 12 zur Herstellung einer lichtabsorbierenden Folie einer photovoltaischen Zelle, wobei:

--- eine Menge der besagten kolloidalen Dispersion auf einem festen Träger angeordnet wird, um eine Folie der besagten kolloidalen Dispersion zu bilden, die sich an der Oberfläche des besagten Trägers erstreckt und eine Dicke von 0,1 $\mu$m bis 5 $\mu$m aufweist, dann;
--- ein Behandlungsschritt durch Sintern der besagten Folie unter einer Se-Atmosphäre durchgeführt wird.

**Claims**

1. Material in the divided state formed by solid particles with the following general composition (A):

$$(Cu^{+1}_2; Zn^{+2}_{a-v-(y/2)}; Cd^{+2}_v; Sn^{+4}_{b-w-(y/2)}; {}^1X^{+4}_w; {}^2X^{+3}_y; S^{-2}_{c-x}; Se^{-2}_x) \qquad (A),$$

where:

*a, b, c, v, w, x* and *y* and the arithmetic combinations thereof are real numbers that represent the molar proportion of each element with which each number is associated in formula (A), and such that:

- ○ $1 \leq a < 1.65$;
- ○ $1 \leq b < 1.40$;
- ○ $4 < c < 9$, and;
- ○ *v, w, x*, and *y* belong independently of one another to all the real numbers belonging to the interval [0; 0.5[, and,

  - $^1X^{+4}$ is chosen from the group formed by titanium (Ti) cations, zirconium (Zr) cations and lead (Pb) cations,
  - $^2X^{+3}$ is chosen from the group formed by gallium (Ga) cations, indium (In) cations and yttrium (Y) cations;

  said material having:

  - by analysis of said material by x-ray diffraction, a unique crystalline structure;
  - by elementary analysis, a proportion by mass of carbon element of less than 2.5%.

2. A material according to claim 1, **characterised in that** it is suitable for being able to form a colloidal dispersion of said material in the divided state in an aqueous liquid phase chosen from the group formed by aqueous solutions and mixed solutions of water and at least one solvent miscible in water.

3. A material according to one of claims 1 or 2, **characterised in that** the solid particles of the material in the divided state have:

   - a mean equivalent diameter of between 15 nm and 350 nm, and
   - at least one domain, named the crystalline domain, with a mean size, measured by x-ray diffraction, of between 3 nm and 100 nm, said crystalline domain having a unique crystalline structure.

4. A material according to one of claims 1 to 3, **characterised in that** the solid particles of the material in the divided state have, by Raman spectroscopy, a diffusion line, named the primary line, having a maximum diffusion intensity at a wave number of between 310 cm$^{-1}$ and 340 cm$^{-1}$.

5. Colloidal dispersion of a material in the divided state according to claim 1, in an aqueous liquid phase chosen from the group formed by aqueous solutions and mixed solutions of water and at least one solvent miscible in water; the colloid dispersion having a concentration of the material in the divided state in said colloidal dispersion greater than 20 g/litre; the colloidal dispersion having a value, determined by electrophoretic mobility analysis of said dispersion, of potential $\zeta$, named the zeta potential, with a negative charge and with an absolute value greater than 20 mV.

6. A colloidal dispersion according to claim 5, **characterised in that** the solid particles of the material in the divided state have a mean equivalent diameter of between 15 nm and 350 nm.

7. A colloidal dispersion according to one of claims 5 to 7, **characterised in that** the material in the divided state has at least one domain, named the crystalline domain, with a mean size, measured by x-ray diffraction, of between 3 nm and 100 nm, said crystalline domain having the unique crystalline structure.

8. A colloidal dispersion according to one of claims 5 to 7, **characterised in that** it is suitable for more than 50% by weight of the material in the divided state remaining in suspension in the colloidal dispersion after treatment of said colloidal dispersion by centrifugation at an acceleration of 1250 g for a period of 10 minutes.

9. A colloidal dispersion according to one of claims 5 to 8, **characterised in that** the solvent miscible in water is chosen from the group formed by alcohols and acitonitrile.

10. A colloidal dispersion according to one of claims 5 to 9, **characterised in that** the solid particles of the material in the divided state have, by Raman spectrosopy, a diffusion line, named the primary line, having a maximum diffusion intensity at a wave number of between 310 cm$^{-1}$ and 340 cm$^{-1}$, said primary line having a line width halfway up of between 5 cm$^{-1}$ and 60 cm$^{-1}$.

11. A colloidal dispersion according to one of claims 5 to 10, **characterised in that** the material in the divided state has, by infrared spectrometry analysis, at least one absorption band having a maximum absorption intensity at a wave number of between 1390 cm$^{-1}$ and 1420 cm$^{-1}$ and a maximum absorption intensity at a wave number of between 1590 cm$^{-1}$ and 1625 cm$^{-1}$.

12. A colloidal dispersion according to one of claims 5 to 11, **characterised in that** the aqueous liquid phase comprises at least one solute chosen from the group formed by $(NH_4)_2S$, $Sn_2S_6(NH_4)_4$, metal complexes based on Zn, Sn, Ga and In and nanoparticles based on Zn and Sn in a proportion by mass in the aqueous phase of less than 10% of the total dry mass of the colloidal dispersion.

13. Method for preparing a colloidal dispersion according to one of claims 5 to 12, in which:

- an aqueous solution of metal cation salts chosen from the group formed by $Zn^{2+}$, $Sn^{2+}$, $Sn^{4+}$, $Cd^{2+}$, $In^{3+}$, $Ga^{3+}$ and $Y^{3+}$ and at least one mineral acid, the molar concentration of of the metal cations in the aqueous solution being between 0.05 mol/litre and 0.5 mol/litre, then
- an aqueous or hydroalcoholic solution, named a sulphide solution, of at least one sulphide chosen from the group formed by $Na_2S$ and $(NH_4)_2S$ is prepared, then
- at least one step of adding the aqueous solution of metal cation salts in the sulphide solution is performed so as to form a solution of metal sulphide complexes, named an inorganic cluster, then:
- the following are put in contact and incubated:

o a quantity of the inorganic cluster solution;
o a quantity of particles having:

▪ by x-ray diffraction, a $Cu_2 Zn Sn S_4$ crystalline structure of the Kesterite or doped Kesterite type, and
▪ a mean equivalent diameter of between 15 nm and 350 nm;

◦ optionally, a quantity of an aqueous solution of at least one sulphide at a concentration of between 0.01 mol/litre and 1 mol/litre;

- a step of separation - in particular by centrifugation - of the solid particles and the aqueous solution is performed;
- the residue is dispersed with an aqueous or hydroalcoholic solution optionally containing at least one sulphide of the $(NH_4)_2S$ type, so as to form a colloidal suspension of a material in the divided state in an aqueous liquid phase, the material in the divided state having, by elementary ananlysis, a proportion by mass of carbon element of less than 2.5%,
the colloidal dispersion having a concentration of the material in the divided state in said colloidal dispersion greater than 20 g/litre.

14. Use of a colloidal dispersion according to one of claims 5 to 12 for manufacturing a photoabsorbant film of a photovoltaic cell, in which:

- a quantity of said colloidal dispersion is placed on a solid support so as to form a film of said colloidal dispersion lying on the surface of said support and with a thickness of between 0.1 $\mu$m and 5 $\mu$m, then
- a step of treatment of said film by sintering in an Se atmosphere is performed.

Fig 1

**EP 2 683 656 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2011030055 A

**Littérature non-brevet citée dans la description**

- **STEINHAGEN et al.** *J. Am. Chem. Soc.,* 2009, vol. 131, 12554-12555
- **GUO et al.** *JACS,* 2009, vol. 131 (33), 11672-11673
- **TODOROV et al.** *Thin Solid Films,* 2009, vol. 517 (7), 2541-2544
- *J. Am. Chem. Soc.,* 2010, vol. 132 (29), 10085-10092
- *J. Solid. Stat. Chem.,* 2003, vol. 175, 359-365